# EUROPEAN PATENT APPLICATION

(11) **EP 2 657 995 A2**
(43) Date of publication of application: **30.10.2013**
(21) Application number: 12182368.6
(22) Date of filing: 30.08.2012
(51) Int. Cl.: H01L 33/44

(54) **Semiconductor light emitting device and method for manufacturing same**

(30) Priority: 27.04.2012 JP 2012103982
(71) Applicant: Kabushiki Kaisha Toshiba, Tokyo 105-8001 (JP)
(72) Inventor: Akimoto, Yosuke, Tokyo, 105-8001 (JP); Shimada, Miyoko, Tokyo, 105-8001 (JP); Kojima, Akihiro, Tokyo, 105-8001 (JP); Tomizawa, Hideyuki, Tokyo, 105-8001 (JP); Sugizaki, Yoshiaki, Tokyo, 105-8001 (JP); Furuyama, Hideto, Tokyo, 105-8001 (JP)
(74) Representative: HOFFMANN EITLE

(57) **Abstract**

According to an embodiment, a method for manufacturing a semiconductor light emitting device includes steps for forming a fluorescent substance layer (30) on a first face of a semiconductor layer (15) and forming a light shielding film (35) on the side face of the fluorescent substance layer (30). The fluorescent substance layer (30) includes a resin (31) and fluorescent substances (32) dispersed in the resin (31), and have a light emitting face on a side opposite to the first face of the semiconductor layer (15) and a side face connecting to the light emitting face with an angle of 90 degree or more between the light emitting face and the side face. The light shielding film (35) shields a light emitted from a light emitting layer (13) included in the semiconductor layer (15) and a light radiated from the fluorescent substances (32).

## Description

### FIELD

Embodiments are generally related to a semiconductor light emitting device and a method for manufacturing the same.

### BACKGROUND

Semiconductor light emitting devices that emit visible light such as white light or light of the other wavelength band will be widely used as small-sized and easily handled light sources. Such a device includes a semiconductor light emitting element and fluorescent substances, and emits light combining the radiations of the semiconductor light emitting element and the fluorescent substances. Thus, there is a demand for realizing the light distributing characteristics suitable for each use at low cost.

For example, the light distribution can be controlled by an enclosure that reflects radiation light provided in a package that houses a semiconductor light emitting element. However, the manufacturing process of the semiconductor light emitting device having the enclosure is complicated, and it is difficult to reduce the manufacturing cost. Accordingly, there is needs for a semiconductor light emitting device that can control the light distribution at low cost and a manufacturing method thereof.

### BRIEF DESCRIPTION OF THE DRAWINGS

FIG. 1 is a schematic cross-sectional view of a semiconductor light emitting device according to a first embodiment;
FIGS. 2A to 15B are schematic views illustrating manufacturing process of the semiconductor light emitting device according to the first embodiment;
FIG. 16 is a schematic cross-sectional view of a semiconductor light emitting device according to a variation of the first embodiment;
FIG. 17 is a schematic cross-sectional view of a semiconductor light emitting device according to another variation of the first embodiment;
FIG. 18 is a schematic cross-sectional view of a semiconductor light emitting device according to other variation of the first embodiment;
FIGS. 19A to 19C are schematic views of a semiconductor light emitting device according to a second embodiment;
FIG. 20 is a schematic cross-sectional view of a light emitting module, in which the semiconductor light emitting device illustrated in FIGS. 18A to 18B is mounted on a mounting substrate;
FIG. 21 is a schematic view of a semiconductor light emitting device according to a third embodiment;
FIGS. 22A to 25B are schematic views illustrating manufacturing process of the semiconductor light emitting device according to the first embodiment;
FIGS. 26A to 26C are schematic cross-sectional views of semiconductor light emitting devices according to a variation of the third embodiment; and
FIGS. 27A to 27C are schematic cross-sectional views of semiconductor light emitting devices according to another variation of the third embodiment.

### DETAILED DESCRIPTION

According to an embodiment, a method for manufacturing a semiconductor light emitting device includes steps for forming a fluorescent substance layer on a first face of a semiconductor layer and forming a light shielding film on the side face of the fluorescent substance layer. The fluorescent substance layer includes a resin and fluorescent substances dispersed in the resin, and have a light emitting face on a side opposite to the first face of the semiconductor layer and a side face connecting to the light emitting face with an angle of 90 degree or more between the light emitting face and the side face. The light shielding film shields a light emitted from a light emitting layer included in the semiconductor layer and a light radiated from the fluorescent substances.

Embodiments will be described with reference to the drawings. Like reference numerals in the drawings denote like elements, and the descriptions of the like elements are appropriately omitted and the different elements are described.

### First Embodiment

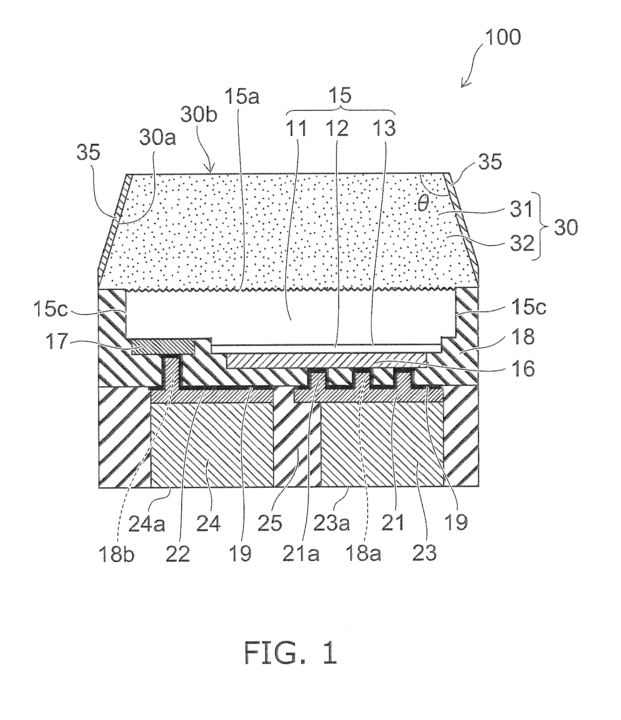

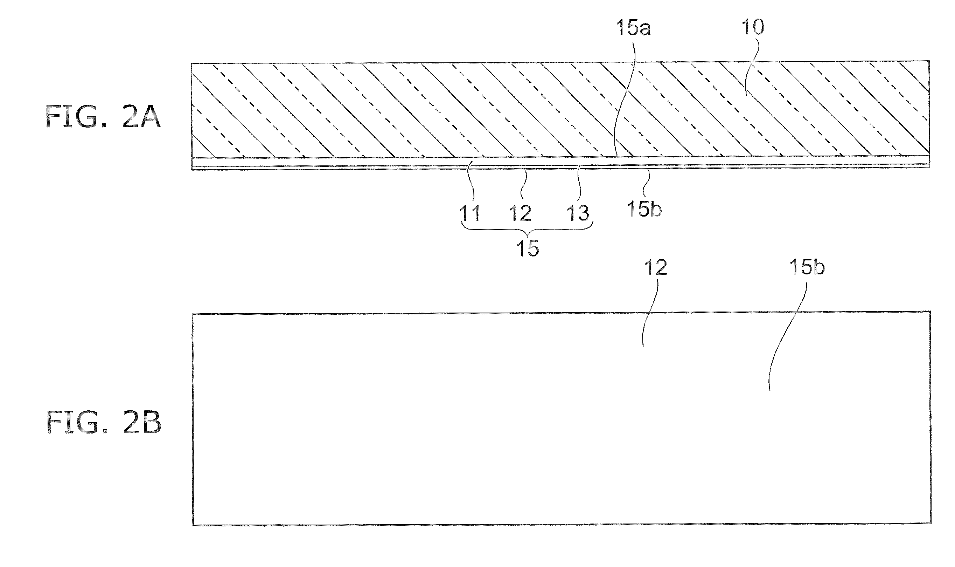

FIG. 1 is a schematic cross-sectional view of a semiconductor light emitting device 100 according to a first embodiment. The semiconductor light emitting device 100 includes a semiconductor layer 15 that includes a light emitting layer 13 and a fluorescent substance layer 30. The semiconductor layer 15 has a first face 15a and a second face 15b (see FIG. 2A) that is located on a side opposite to the first face 15a. The fluorescent substance layer 30 is provided on the first face 15a and includes a transparent resin 31 and fluorescent substances 32 that are dispersed in the transparent resin 31.

As shown in FIG. 1, the fluorescent substance layer 30 includes a light emitting face 30b facing the first face 15a and a side surface 30a that is in contact with the light emitting face 30b. In addition, a light shielding film 35 provided on the side surface 30a of the fluorescent substance layer 30 controls the light distribution. The light shielding film 35 shields the light radiated from the light emitting layer 13 and light radiated from the fluorescent substances 32.

Hereinafter, the configuration of the light emitting device 100 will be described in detail with reference to FIG. 1.

The semiconductor light emitting device 100 includes a semiconductor layer 15 that includes a light emitting layer 13. In addition, the semiconductor layer 15 has a first face 15a and a second face that is located on a side opposite to the first face 15a. On a second face side, electrodes and an interconnection part are provided, and light is emitted mainly to the outer side from the first face 15a on which the electrodes and the interconnection part are not provided.

The semiconductor layer 15 includes a first semiconductor layer 11 and a second semiconductor layer 12. The first semiconductor layer 11 and the second semiconductor layer 12, for example, contain gallium nitride. The first semiconductor layer 11 may include an underlying buffer layer, an n-type GaN layer, and the like. The second semiconductor layer 12 includes a p-type GaN layer, a light emitting layer (active layer) 13, and the like. The light emitting layer 13 may include a material that emits blue light, purple light, blue-purple light, ultraviolet light, or the like.

The second face of the semiconductor layer 15 is formed in a concavo-convex shape, and a convex part includes the light emitting layer 13. A p-side electrode 16 is provided on the surface of the second semiconductor layer 12, which is the surface of the convex part. In other words, the p-side electrode 16 is provided on a first region of the second face that is the top surface of the convex part of the semiconductor layer 15.

In the semiconductor layer 15, a part that does not include the light emitting layer 13 is provided on a side of the convex part, where the light emitting layer 13 is removed and a surface of the first semiconductor layer 11 is exposed. An n-side electrode 17 is provided on the exposed surface of the first semiconductor layer 11. In other words, the n-side electrode 17 is provided in a second region of the second surface that is the surface of the part not including the light emitting layer 13.

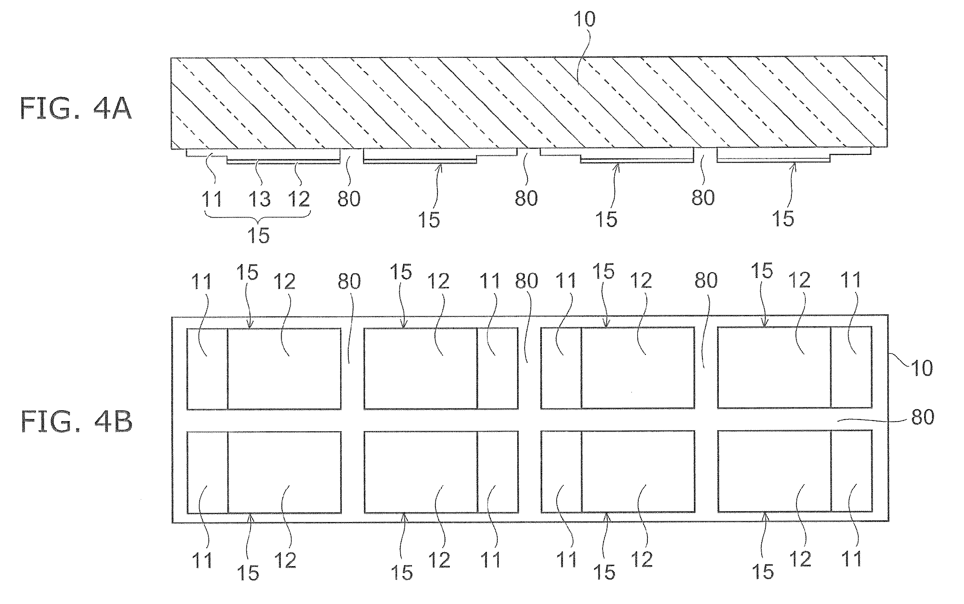

As shown in FIG. 4B, the first region is larger than the second region in the second face of the semiconductor layer 15. That is, the area of the second semiconductor layer 12 that includes the light emitting layer 13 is larger than the exposed area of the first semiconductor layer 11 that does not include the light emitting layer 13.

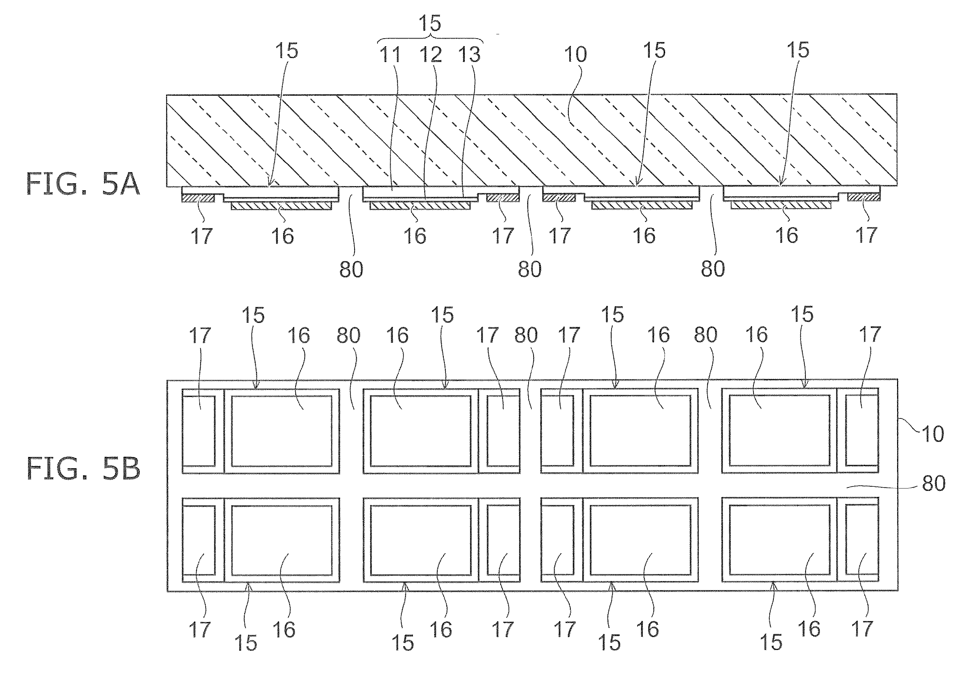

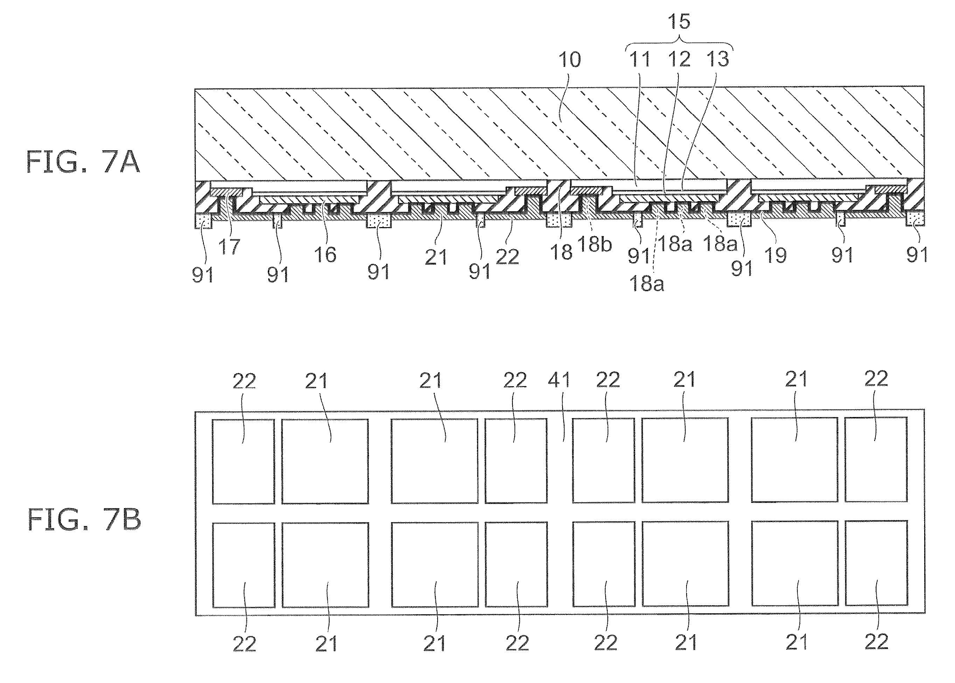

In addition, as shown in FIG. 5B, on the semiconductor layer 15, the area of the p-side electrode 16 that is provided on the first region that includes the light emitting layer 13 is larger than the area of the n-side electrode 17 that is provided on the second region that does not include the light emitting layer 13. Accordingly, a relatively wide light emitting area is obtained. Here, the layout of the p-side electrodes 16 and the n-side electrodes 17, which is shown in FIG. 7B, is an example, and the embodiment is not limited thereto.

A first insulating film (hereinafter, simply referred to as an insulating film 18) is provided on the second face side of the semiconductor layer 15. The insulating film 18 covers the semiconductor layer 15, the p-side electrode 16, and the n-side electrode 17. In addition, the insulating film 18 covers the side surfaces of the light emitting layer 13 and the second semiconductor layer 12 for the protection thereof.

In addition, another insulating film (for example, a silicon oxide film) may be provided between the insulating film 18 and the semiconductor layer 15. The insulating film 18, for example, is formed of a resin such as polyimide that is superior for the patterning of fine openings. Alternatively, an inorganic film such as a silicon oxide film or a silicon nitride film may be used as the material of the insulating film 18.

The insulating film 18 is not provided on the first face 15a. The insulating film 18 covers a side surface 15c for the protection, which extends from the first face 15a to the second face in the semiconductor layer 15.

A p-side interconnection layer 21 and an n-side interconnection layer 22 are provided on a face of the insulating film 18 opposite to the second face of the semiconductor layer 15, so as to be separated from each other.

Parts of the p-side interconnection layer 21 are provided in a plurality of first openings 18a that are formed in the insulating film 18 up to the p-side electrodes 16, and the p-side interconnection layer 21 is electrically connected to the p-side electrodes 16. A part of the n-side interconnection layer 22 is also provided in a second opening 18b that is formed in the insulating film 18 up to the n-side electrodes 17, and the n-side interconnection layer 22 is electrically connected to the n-side electrodes 17.

A p-side metal pillar 23 is provided on a face of the p-side interconnection layer 21 opposite to the p-side electrode 16. Then, a p-side interconnection according to the embodiment includes the p-side interconnection layer 21, the p-side metal pillar 23, and a metal film 19 that serves as a seed layer to be described later.

An n-side metal pillar 24 is provided on a face of the n-side interconnection layer 22 opposite to the n-side electrodes 17. Then, an n-side interconnection according to the embodiment includes the n-side interconnection layer 22, the n-side metal pillar 24, and the metal film 19 that is used as the seed layer.

A resin layer 25 serving as a second insulating film is stacked on the insulating film 18. The resin layer 25 covers the periphery of the p-side interconnection and the periphery of the n-side interconnection. In addition, the resin layer 25 is filled up between the p-side metal pillar 23 and the n-side metal pillar 24.

The side surfaces of the p-side metal pillar 23 and the n-side metal pillar 24 are covered with the resin layer 25. A face of the p-side metal pillar 23 opposite to the p-side interconnection layer 21 is exposed from the resin layer 25 and serves as a p-side external terminal 23a. A face of the n-side metal pillar 24 opposite to the n-side interconnection layer 22 is exposed from the resin layer 25 and serves as an n-side external terminal 24a.

The p-side external terminal 23a and the n-side external terminal 24a are bonded to a pad formed in a mounting substrate through a bonding member such as a solder, other metal, a material having conductivity, or the like.

The p-side external terminal 23a and the n-side external terminal 24a are exposed on the same face (the lower face in FIG. 1) of the resin layer 25, having a longer distance therebetween than a distance between the p-side interconnection layer 21 and the n-side interconnection layer 22 on the insulating film 18. The p-side external terminal 23a and the n-side external terminal 24a are separated from each other with such a distance, so that the external terminals do not form a short circuit via solder or the like at the time of being mounted on the mounting substrate.

On the other hand, the p-side interconnection layer 21 may approach the n-side interconnection layer 22 up to a process limit, and accordingly, the area of the p-side interconnection layer 21 may be widened. Thereby, the contact area can be enlarged between the p-side interconnection layer 21 and the p-side electrode 16.

Furthermore, the area of the p-side interconnection layer 21 that is in contact with the p-side electrodes 16 through the plurality of first openings 18a is possible to be larger than the area of the n-side interconnection layer 22 that is in contact with the n-side electrodes 17 through the second openings 18b.

As a result, the current distribution toward the light emitting layer 13 is improved, and the heat dissipation of the light emitting layer 13 can be improved.

In the n-side interconnection layer 22, the portion extending on the insulating film 18 can be formed to have larger area than the contact portion that is in contact with the n-side electrodes 17.

According to the embodiment, a high optical output can be acquired, since the light emitting layer 13 is formed over the first region that is larger than the second region on which the n-side electrode 17 is provided. In addition, the n-side interconnection layer 22 having a larger area than the n-side electrode 17 can be provided on the mounting face side.

The first semiconductor layer 11 is electrically connected to the n-side metal pillar 24 having the n-side external terminal 24a through the n-side electrode 17, the metal film 19, and the n-side interconnection layer 22. The second semiconductor layer 12 including the light emitting layer 13 is electrically connected to the p-side metal pillar 23 having the p-side external terminal 23a through the p-side electrode 16, the metal film 19, and the p-side interconnection layer 21.

The p-side metal pillar 23 is thicker than the p-side interconnection layer 21, and the n-side metal pillar 24 is thicker than the n-side interconnection layer 22. Each thickness of the p-side metal pillar 23, the n-side metal pillar 24, and the resin layer 25 is larger than that of the semiconductor layer 15. Here, the "thickness" represents a thickness in the vertical direction in FIG. 1.

In addition, each thickness of the p-side metal pillar 23 and the n-side metal pillar 24 is larger than that of a stacked body that includes the semiconductor layer 15, the p-side electrode 16, the n-side electrode 17, and the insulating film 18. In addition, the aspect ratio (the ratio of the thickness to the planar size) of each one of the metal pillars 23 and 24 is not limited to be one or more, and the ratio may be less than one. In other words, each thickness of the metal pillars 23 and 24 may be smaller than the planar size of the metal pillars 23 and 24.

According to the embodiment, even though a substrate 10 used for forming the semiconductor layer 15 is removed as described later, the mechanical strength of the semiconductor light emitting device 100 can be maintained, since the semiconductor layer 15 is stably supported by the p-side metal pillar 23, the n-side metal pillar 24, and the resin layer 25.

Copper, gold, nickel, silver, and the like can be used as the materials of the p-side interconnection layer 21, the n-side interconnection layer 22, the p-side metal pillar 23, and the n-side metal pillar 24. Among these materials, copper is superior to the other material in thermal conductivity, resistance for migration, and adhesiveness to an insulating material.

The resin layer 25 reinforces the p-side metal pillar 23 and the n-side metal pillar 24. It is preferable that the thermal expansion coefficient of the resin layer 25 is the same as or close to the thermal expansion coefficient of the mounting substrate. As examples of such a resin layer 25, there are an epoxy resin, a silicone resin, a fluorine resin, and the like.

In addition, when the semiconductor light emitting device 100 is mounted on the mounting substrate through the p-side external terminal 23a and the n-side external terminal 24a, the stress applied to the semiconductor layer 15 through soldering or the like can be absorbed and relieved by the p-side metal pillar 23 and the n-side metal pillar 24.

The p-side interconnection that includes the p-side interconnection layer 21 and the p-side metal pillar 23 is connected to the p-side electrode 16 through a plurality of vias 21a that are provided inside the plurality of first openings 18a and are separated from each other. Accordingly, an effective stress relieving can be obtained through the p-side interconnection.

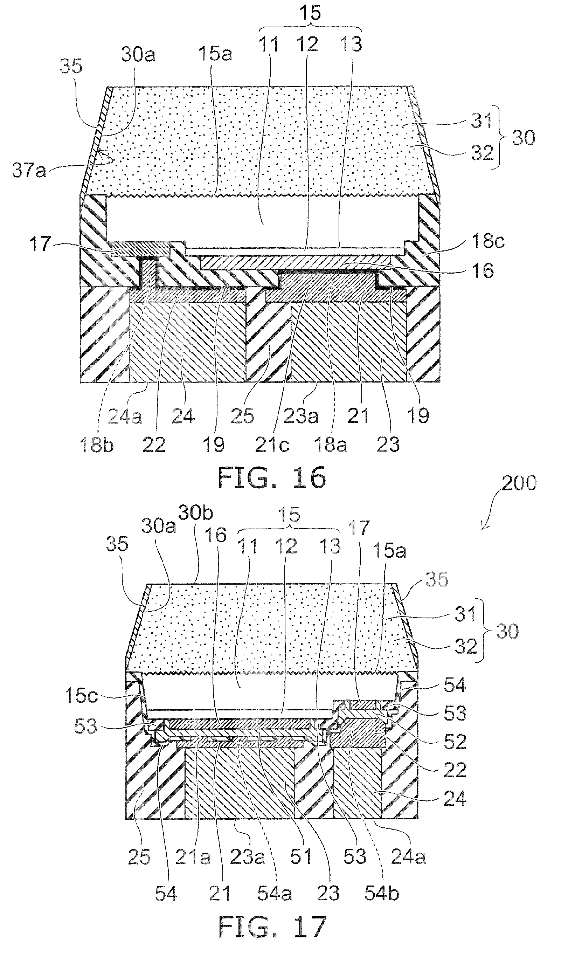

Alternatively, as shown in FIG. 16, the p-side interconnection layer 21 may be connected to the p-side electrode 16 through a post 21c that is provided inside one large first opening 18a and has a planar size larger than the via 21a. In such a case, the heat dissipation of the light emitting layer 13 can be improved through the p-side electrode 16, the p-side interconnection layer 21, and the p-side metal pillar 23, all of which are formed of metal.

As described later, the substrate 10 used for a crystal growth of the semiconductor layer 15 is removed from the first face 15a. Accordingly, the height of the semiconductor light emitting device 100 can be lowered.

A fine concavo-convex is formed on the first face 15a of the semiconductor layer 15 using wet etching (frost process), where an alkali-based solution is applied to the first face 15a. The light emitted from the light emitting layer 13 can be extracted outside through the first face 15a, suppressing light reflection at various incident angles by providing the concavo-convex on the first face 15a.

A fluorescent substance layer 30 is provided on the first face 15a. The fluorescent substance layer 30 includes a transparent resin 31 and a plurality of fluorescent substances 32 dispersed in the transparent resin 31. The transparent resin 31 has transparency for the lights emitted from the light emitting layer 13 and the fluorescent substance 32. For example, a silicone resin, an acrylic resin, a phenyl resin, or the like may be used as the transparent resin 31. The fluorescent substance 32 absorbs the light emitted from the light emitting layer 13 as excited light and emits wavelength-converted light. Accordingly, the semiconductor light emitting device 100 can emit mixed lights emitted from the light emitting layer 13 and the fluorescent substance 32.

In a case where the fluorescent substance 32 is a yellow fluorescent substance that emits yellow light, a white color, a light bulb color, or the like can be obtained as a mixed color of blue light emitted from the light emitting layer 13, which contains a GaN-based material, and the yellow light emitted from the fluorescent substance 32. In addition, the fluorescent substance layer 30 may be configured to contain a plurality of types of fluorescent substances (for example, a red fluorescent substance that emits red light and a green fluorescent substance that emits green light).

In addition, the fluorescent substance layer 30 includes a light emitting face 30b that faces the first face 15a of the semiconductor layer 15. The light shielding film 35 is provided on the side surface 35a that is in contact with the light emitting face 30b. The light shielding film 35, for example, is a metal film that reflects the lights emitted from the light emitting layer 13 and the fluorescent substances 32. Accordingly, outgoing light from the side surface 30a of the fluorescent substance layer 30 is shielded, and the lights emitted from the light emitting layer 13 and the fluorescent substances 32 are output from the light emitting face 30b to the upper side. In addition, a metal protection film (barrier metal) that prevents the sulfuration of silver or the oxidation of aluminum may be provided on the light shielding film 35.

For example, in the fluorescent substance layer 30, an optical path length of light that is emitted from the light emitting layer 13 and propagates in the direction of the side surface 30a is different from an optical path length of the light that propagates in the direction of the light emitting face that is disposed on the upper side. Accordingly, the number of fluorescent substances that are excited by the light propagating in the direction of the side surface 30a is different from the number of fluorescent substances that are excited by the light propagating in the direction of the light emitting face 30b. Thus, the light output from the side surface 30a has the chromaticity different from the light radiated from the light emitting face 30b. In other words, the chromaticity of the light output from the light emitting face 30b and the chromaticity of the light output from the side surface 30a are different from each other, and, accordingly, so-called color breakup may easily occur.

As described above, according to the embodiment, the color breakup is suppressed by shielding the light that is output from the side surface 30a, and the light distribution can be realized in which the outgoing light from the light emitting face 30b is dominant.

In addition, the fluorescent substance layer 30 is provided such that an angle θ between the light emitting face 30b facing the first face 15a and the side surface 30a that is in contact with the light emitting face 30b is 90 degrees or more. Thus, the light shielding film 35 can be easily formed, thereby the manufacturing cost can be reduced.

Next, a method of manufacturing the semiconductor light emitting device 100 according to the embodiment will be described with reference to FIGS. 2A to 15B. FIGS. 2A to 15B show partial areas of a wafer.

FIG. 2A is a schematic cross-sectional view of a stacked body in which a first semiconductor layer 11 and a second semiconductor layer 12 are formed on a major face (the lower face in FIG. 2A) of a substrate 10. FIG. 2B is a schematic view corresponding to a lower face in FIG. 2A.

The first semiconductor layer 11 is formed on the major face of the substrate 10, and the second semiconductor layer 12 including a light emitting layer 13 is formed thereon. For example, the first semiconductor layer 11 and the second semiconductor layer 12 may contain gallium nitride, and grown on a sapphire substrate by using a metal organic chemical vapor deposition (MOCVD) method. Alternatively, a silicon substrate may be used as the substrate 10.

A first face 15a of the semiconductor layer 15 is a face through which the first semiconductor layer 11 is in contact with the substrate 10, and a second face 15b of the semiconductor layer 15 is the surface of the second semiconductor layer 12 opposite to the first semiconductor layer 11.

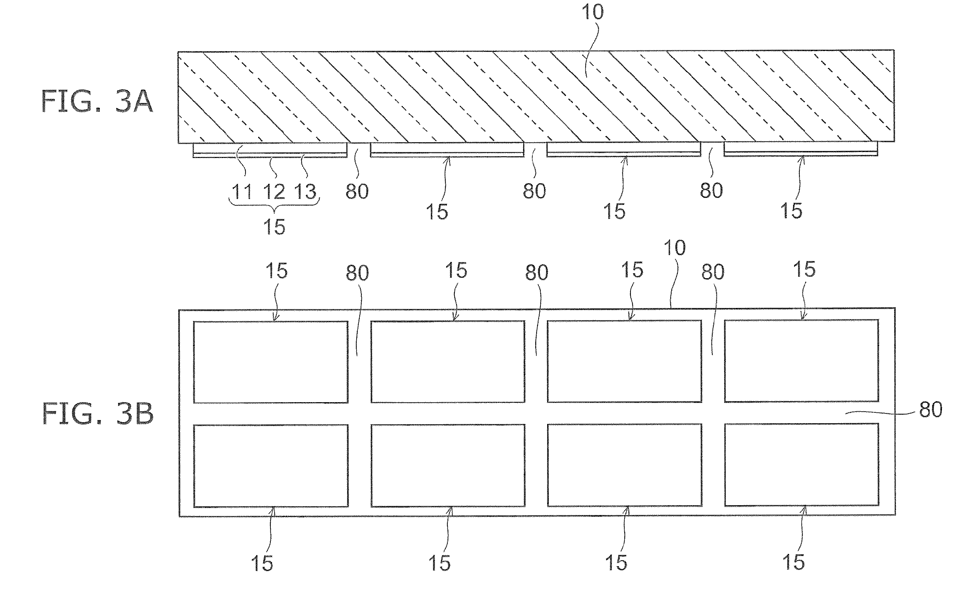

Next, as shown in FIG. 3A, a groove 80 is formed passing through the semiconductor layer 15 and reaching the substrate 10, for example, by using a reactive ion etching (RIE) method using a resist mask (not shown). As shown FIG. 3B corresponding to the lower face of FIG. 3A, the groove 80 is formed, for example, in a lattice pattern on the substrate 10, and separates the semiconductor layer 15 into a plurality of chips on the substrate 10.

Alternatively, the process for separating the semiconductor layer 15 into multiple parts may be performed after selectively removing the second semiconductor layer 12, or after forming the p-side electrode 16 and the n-side electrode.

Next, as shown in FIG. 4A and FIG. 4B corresponding to the lower face of FIG. 4A, parts of the second semiconductor layer 12 are removed so as to expose parts of the first semiconductor layer 11, for example, by using the RIE method using a resist mask (not shown). Each region in which the first semiconductor layer 11 is exposed does not include the light emitting layer 13.

Next, as shown in FIG. 5A and FIG. 5B corresponding to the lower face of FIG. 5A, p-side electrodes 16 and n-side electrodes 17 are formed on the second face of the semiconductor layer 15. The p-side electrodes 16 are formed on the surfaces of the second semiconductor layer 12. The n-side electrodes 17 are formed on the exposed surfaces of the first semiconductor layer 11.

The p-side electrodes 16 and the n-side electrodes 17, for example, are formed using a sputtering method, a vapor deposition method, or the like. Either the p-side electrodes 16 or the n-side electrodes 17 may be formed first, or the p-side electrode 16 and n-side electrodes 17 may be simultaneously formed and inevitably made of the same material.

The p-side electrode 16 has preferably formed so as to reflect the light emitted from the light emitting layer 13. Hence, the p-side electrode 16 may include silver, silver alloy, aluminum, aluminum alloy, and the like. In addition, the p-side electrode 16 may include a metal protective film (barrier metal) formed on the reflection electrode, in order to prevent the reflection electrode from the sulfurization and the oxidization.

In addition, a silicon nitride film or a silicon oxide film may be formed as a passivation film by using a chemical vapor deposition (CVD) method between the p-side electrode 16 and the n-side electrode 17 or on the end face (side surface) of the light emitting layer 13. In addition, activated annealing may be performed as necessary for forming an ohmic contact between each electrode and the semiconductor layer.

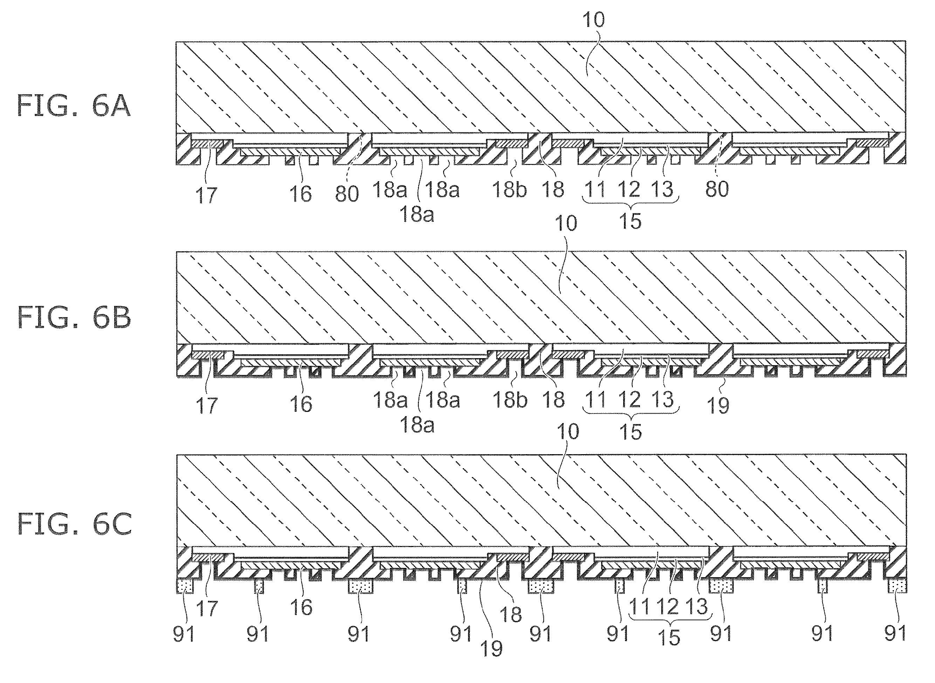

Next, after all the parts formed on the major face of the substrate 10 are covered with an insulating film 18 shown in FIG. 6A, and the insulating film 18 is patterned, for example, by using wet etching, whereby first openings 18a and a second opening 18b are selectively formed in the insulating film 18. A plurality of the first openings 18a are formed in the insulating film 18, and each of the first openings 18a reaches the p-side electrodes 16. The second opening 18b also reaches the n-side electrode 17.

For example, an organic material such as a photosensitive polyimide or benzocyclobutene can be used as the material of the insulating film 18. In such a case, the insulating film 18 can be directly exposed and developed using photo-lithography, and the first and second openings 18a, 18b are directly formed therein without using a resist mask.

Alternatively, an inorganic film such as a silicon nitride film or a silicon oxide film may be used as the insulating film 18. In a case where the insulating film 18 is an inorganic film, the first openings 18a and the second opening 18b are formed using selective etching using a resist mask formed on the insulating film 18.

Next, as shown in FIG. 6B, a metal film 19 is formed on the surface of the insulating film 18, the inner walls (the side wall and the bottom portion) of the first opening 18a, and the inner wall (the side wall and the bottom portion) of the second opening 18b. The metal film 19 is used as a seed metal for plating, which will be described later.

The metal film 19, for example, is formed using a sputtering method. The metal film 19 includes a stacked film, for example, in which a titanium (Ti) layer and a copper (Cu) layer are stacked in order from the insulating film 18 side. Alternatively, an aluminum layer may be used instead of the titanium layer.

Next, as shown in FIG. 6C, resists 91 are selectively formed on the metal film 19, and Cu electroplating is performed using the metal film 19 as a current path.

Accordingly, as shown in FIG. 7A and FIG. 7B corresponding to the lower face of FIG. 7A, a p-side interconnection layer 21 and an n-side interconnection layer 22 are selectively formed on the metal film 19. The p-side interconnection layer 21 and the n-side interconnection layer 22 are simultaneously formed, for example, by using copper plating.

The p-side interconnection layer 21 is also formed inside the first openings 18a and is electrically connected to the p-side electrode 16 via the metal film 19. In addition, the n-side interconnection layer 22 is formed also inside the second openings 18b and is electrically connected to the n-side electrodes 17 via the metal film 19.

The resists 91 that are used for plating the p-side interconnection layer 21 and the n-side interconnection layer 22 are removed using solvent or oxygen plasma.

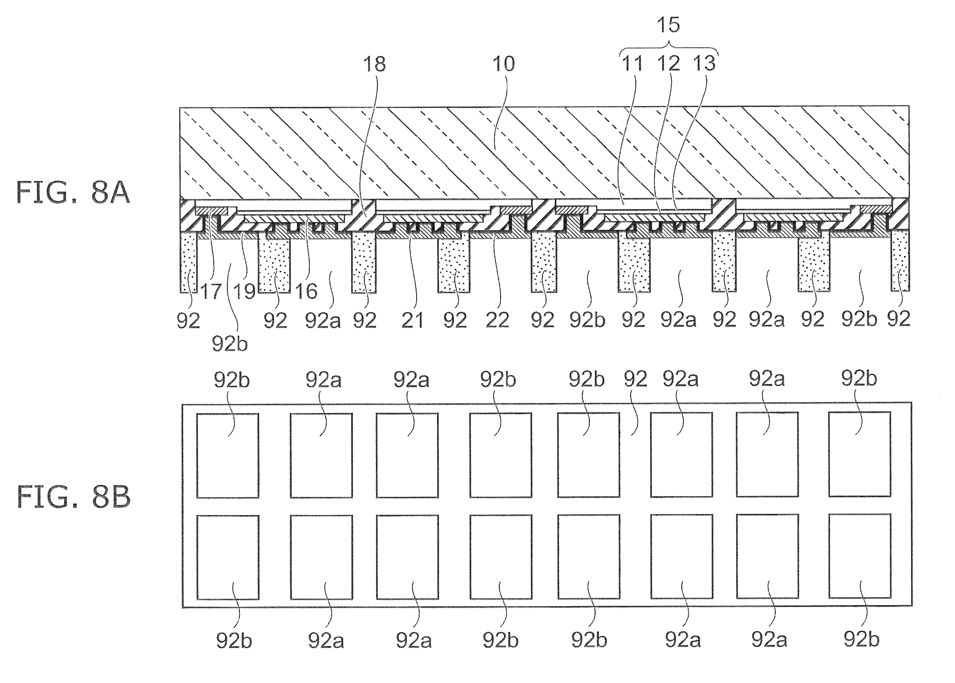

Next, as shown in FIG. 8A and FIG. 8B corresponding to the lower face of FIG. 8A, resists 92 are formed for forming metal pillars. The resist 92 is thicker than the above-described resist 91. It may be possible to leave the resists 91 without removing in the previous process, and the resists 92 are formed so as to overlap the resists 91. First openings 92a and second openings 92b are formed in the resists 92.

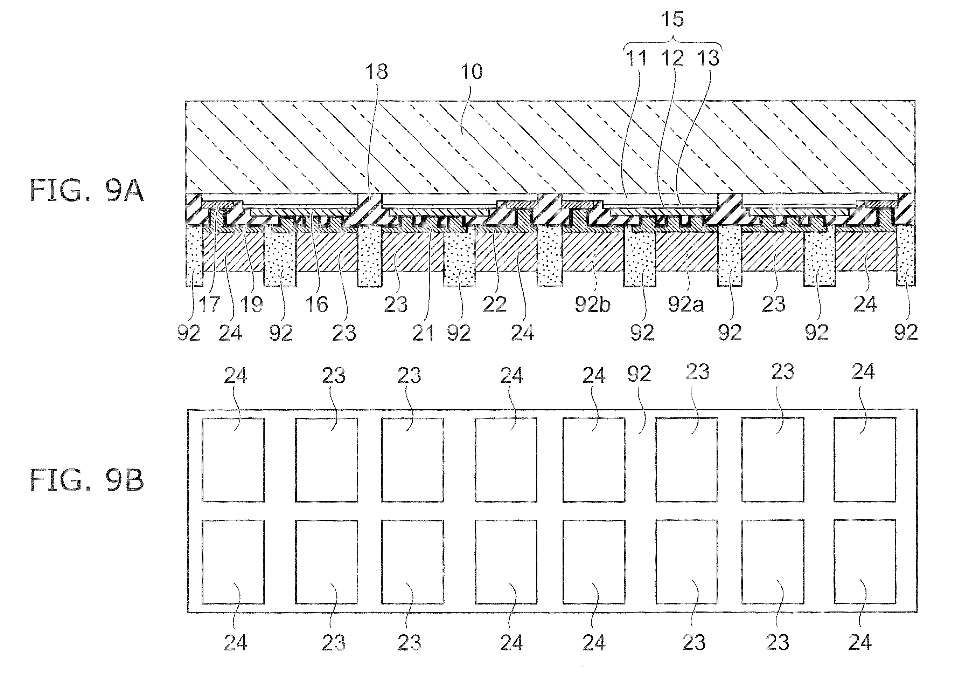

Then, Cu electroplating is performed using the metal film 19 as a current path and the resists 92 as a mask. Accordingly, as shown in FIG. 9A and FIG. 9B corresponding to the lower face of FIG. 9A, a p-side metal pillar 23 and an n-side metal pillar 24 are formed on the p-side interconnection layer 21 and n-side interconnection layer 22 respectively.

The p-side metal pillar 23 is formed on the p-side interconnection layer 21 inside the first opening 92a that is formed in the resist 92. The n-side metal pillar 24 is formed on the n-side interconnection layer 22 inside the second opening 92b that is formed in the resist 92. The p-side metal pillar 23 and the n-side metal pillar 24 are simultaneously formed using copper plating, for example.

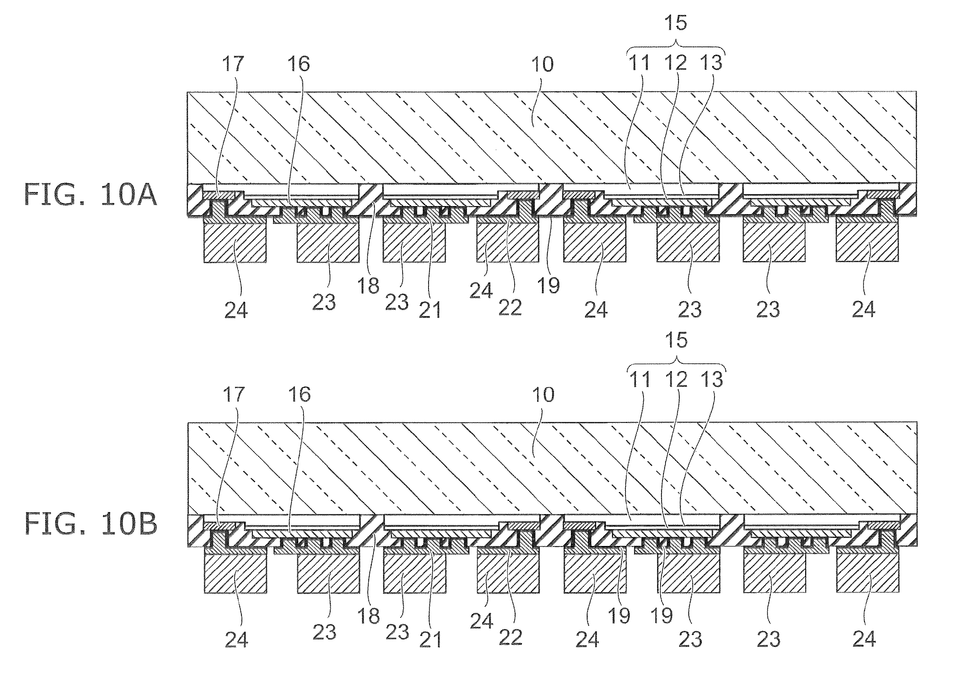

The resist 92, as shown in FIG. 10A is removed, for example, by using solvent or oxygen plasma. Thereafter, exposed parts of the metal film 19 are removed by wet etching while using the p-side metal pillar 23, the n-side metal pillar 24, the p-side interconnection layer 21, and the n-side interconnection layer 22 as a mask. Accordingly, as shown in FIG. 10B, the p-side interconnection layer 21 and the n-side interconnection layer 22 is separated from each other on the insulating film 18, cutting off the electric connection therebetween.

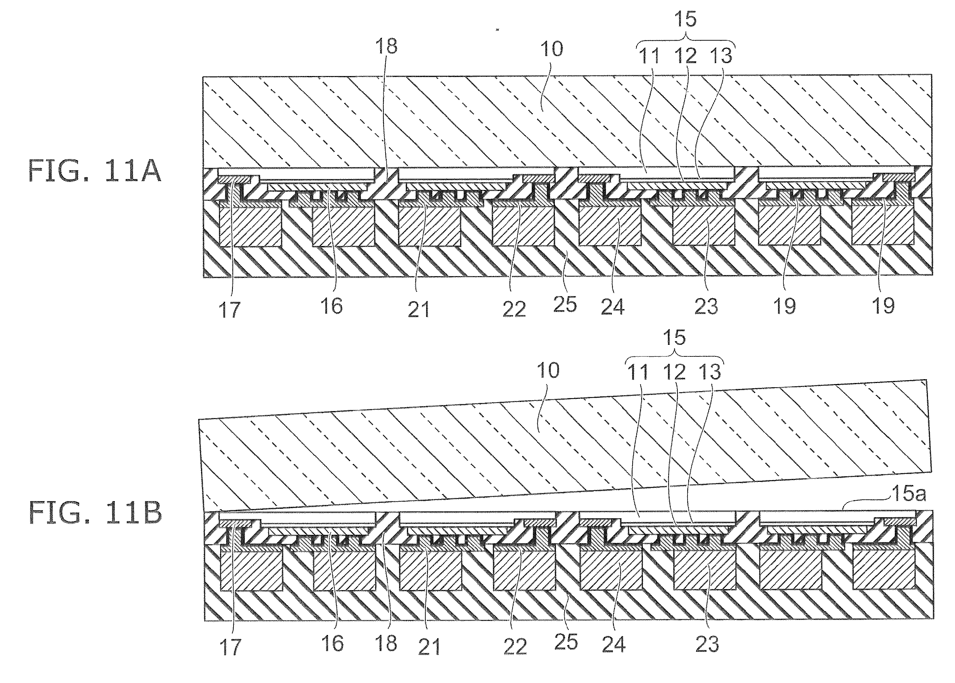

Next, as shown in FIG. 11A, a resin layer 25 is stacked on the insulating film 18. The resin layer 25 covers the p-side interconnection layer 21, the n-side interconnection layer 22, the p-side metal pillar 23, and the n-side metal pillar 24.

The resin layer 25 has an insulating property. In addition, for example, carbon black may be dispersed in the resin layer 25 so as to shield the light emitted from the light emitting layer 13.

Next, the substrate 10 is removed as shown in FIG. 11B. In a case where the substrate 10 is a sapphire substrate, the substrate 10 can be removed, for example, using a laser lift-off method. More specifically, laser light is emitted from the backside of the substrate 10 toward the first semiconductor layer 11. The laser light has transparency for the substrate 10 and has a wavelength in an absorption band of the first semiconductor layer 11.

When the laser light arrives at an interface between the substrate 10 and the first semiconductor layer 11, part of the first semiconductor layer 11 that is located near the interface absorbs energy of the laser light and decomposes. The first semiconductor layer 11 is decomposed into gallium (Ga) and nitrogen gas. According to the decomposition reaction, a minute gap is formed between the substrate 10 and the first semiconductor layer 11, whereby the substrate 10 and the first semiconductor layer 11 are separated from each other.

The laser light is radiated over the whole wafer, scanning a plurality of areas thereof and a plurality of times for each area, whereby the substrate 10 is removed from the first semiconductor layer 11.

In a case where the substrate 10 is a silicon substrate, the substrate 10 can be removed by etching from the first semiconductor layer 11.

The above-described stacked body formed on the major face of the substrate 10 is reinforced by the p-side metal pillar 23 thicker than the semiconductor layer 15, the n-side metal pillar 24, and the resin layer 25, and accordingly, the wafer shape can be maintained even after the substrate 10 is removed therefrom.

In addition, the resin layer 25 and the metal that configures the p-side metal pillar 23 and the n-side metal pillar 24 are more flexible than the material of the semiconductor layer 15. That is, the semiconductor layer 15 is supported by the flexible support members. Accordingly, when strong internal stress contained in the wafer during the epitaxial growth of the semiconductor layer 15 is released at once by removing the substrate 10, the released stress may be absorbed by the resin layer 25, the p-side metal pillar 23 and the n-side metal pillar 24, preventing the semiconductor layer 15 from being destroyed.

The first face 15a of the semiconductor layer 15 is cleaned after removing the substrate 10 therefrom. For example, gallium (Ga) that is stuck to the first face 15a is removed by using rare hydrofluoric acid or the like.

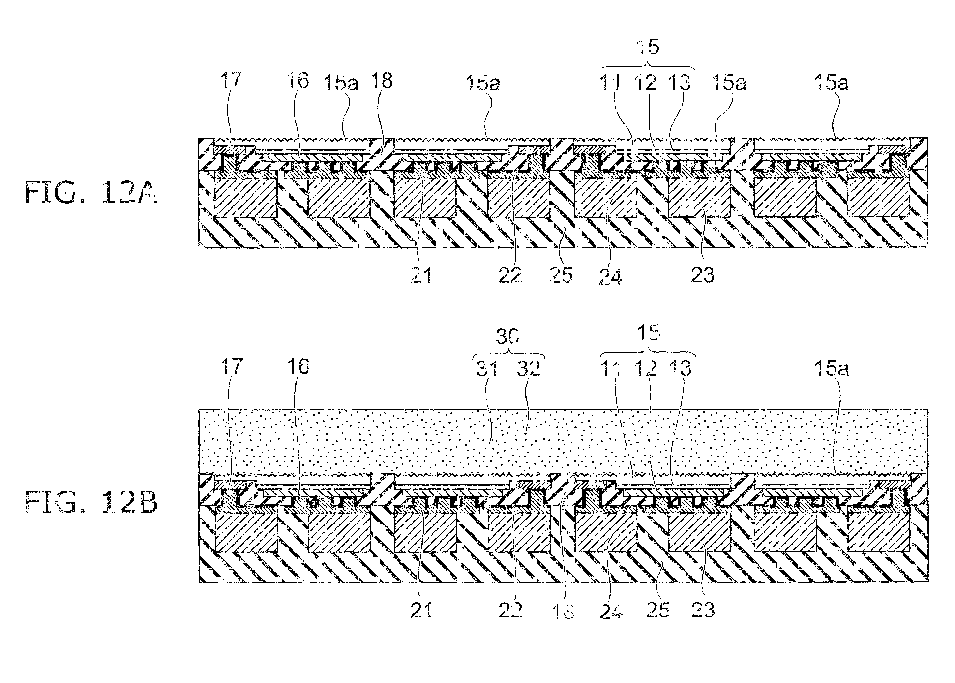

Thereafter, wet etching is performed for the first face 15a, for example, by using a potassium hydroxide (KOH) solution, tetramethylammonium hydroxide (TMAH), or the like. Accordingly, the concavo-convex is formed on the first face 15a due to a difference in the etching speed that depends on the direction of the crystal plane, as shown in FIG. 12A. Alternatively, the concavo-convex may be formed on the first face 15a by etching using a resist mask. The concavo-convex formed on the first face 15amay improve the light extraction efficiency.

Next, as shown in FIG. 12B, a fluorescent substance layer 30 is formed on the first face 15a. The fluorescent substance layer 30 is also formed on the insulating film 18 between semiconductor layers 15 adjacent to each other.

The transparent resin 31 is thermally cured after a transparent resin 31 of a liquid phase in which fluorescent substances 32 are dispersed is supplied to the upper side of the first face 15a, for example, using a method such as a printing method, a potting method, a molding method, or a compression molding.

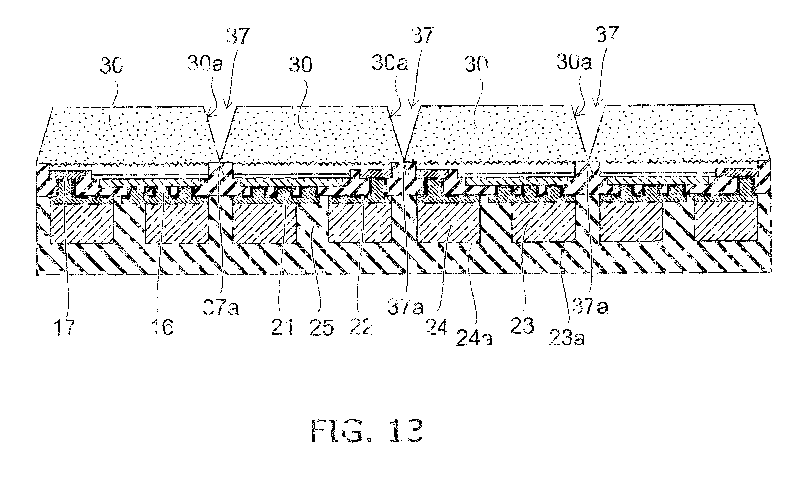

Next, as shown in FIG. 13, grooves 37 including the side surfaces 30a are formed by cutting the fluorescent substance layer 30. The groove 37, for example, is formed in a lattice shape and is formed such that the lower part 37a is located at the center of the above-described groove 80. The groove 37, for example, is a "V" groove and can be formed by cutting the fluorescent substance layer 30 using a dicing blade that is processed in a taper shape. It is preferable that the lower part 37a of the groove 37 is formed in a depth located near the interface between the fluorescent substance layer 30 and the insulating layer 18. Alternatively, the fluorescent substance layer 30 having the "V" groove may be formed using a molding method using a die, an imprinting method, or the like.

Furthermore, it may be possible to form the groove 37 more deeply by cutting both the fluorescent substance layer 30 and the insulating film 18. In such a case, the side surface 37b of groove 37 that is the cutting face of the fluorescent substance layer 30 includes the side surface 30a of the fluorescent substance layer 30 and a part of the insulating layer 18 as shown in FIG. 16. In addition, it is preferable that the groove 37 is provided in a depth so that the side surface 37b does not reach the first semiconductor layer 11, whereby, avoiding an electric short circuit between the light shielding film 35 and the first semiconductor layer 11.

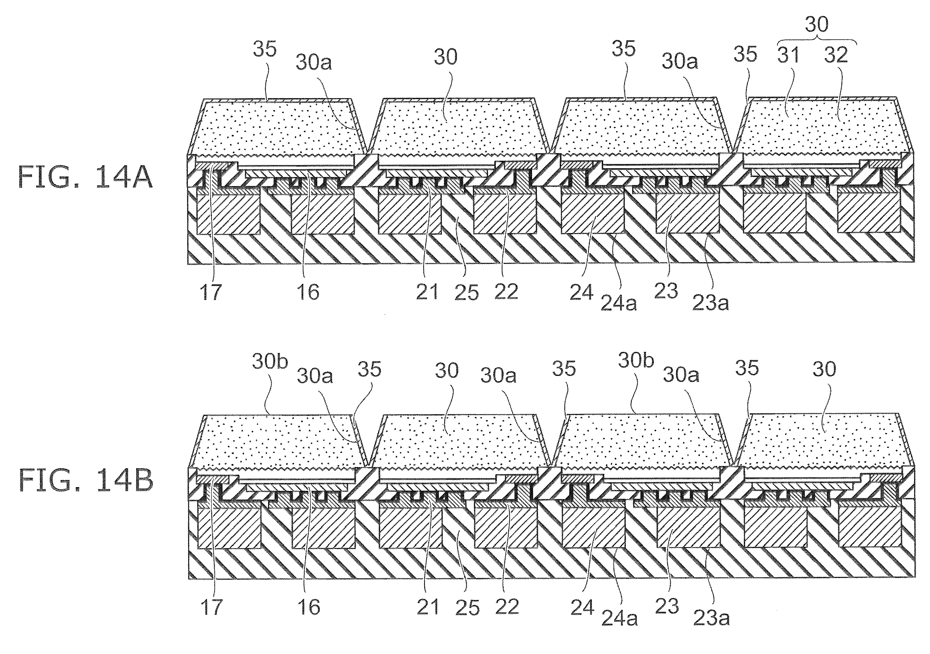

Next, as shown in FIG. 14A, the light shielding film 35 is formed on the upper face and the side surface 30a of the fluorescent substance layer 30. The light shielding film 35, for example, is a metal film that contains silver, a silver alloy, aluminum, an aluminum alloy, or the like and can be formed using a vacuum deposition method or a sputtering method.

Subsequently, as shown in FIG. 14B, the light shielding film 35 that is formed on the upper face of the fluorescent substance layer 30 is removed so as to expose the light emitting face 30b. The light shielding film 35, for example, can be removed by grinding or polishing.

As above described, it is easy to form the light shielding film 35 on the side surface 30a having an angle of 90 degrees or more with respect to the light emitting face 30b. Thereby the color breakup is suppressed through a simple manufacturing process and it is possible to control the light distribution.

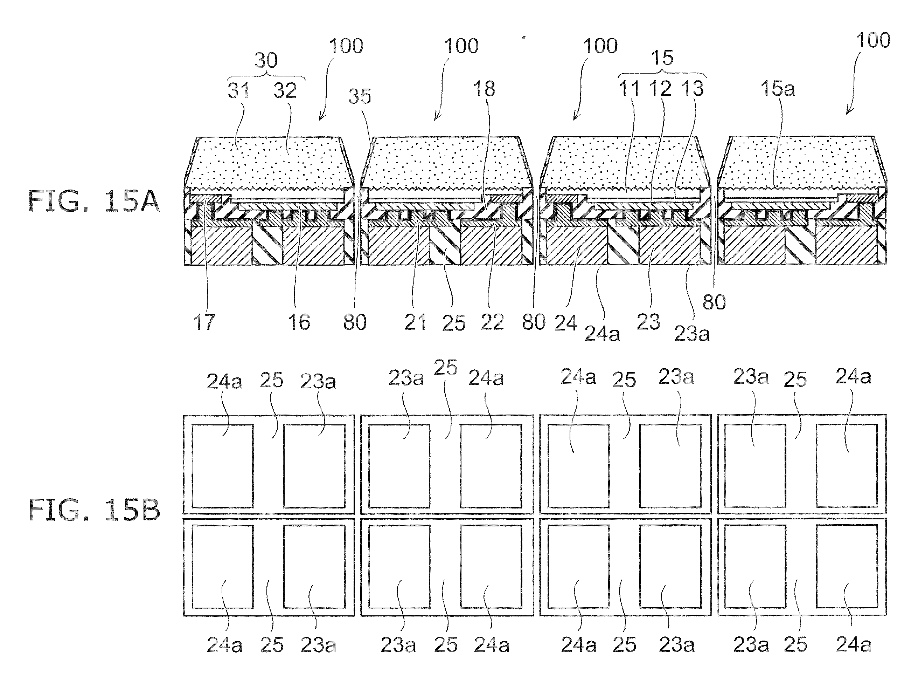

Next, the surface (the lower face in FIG. 12B) of the resin layer 25 is ground such that the p-side external terminals 23a and the n-side external terminals 24a are exposed as shown in FIG. 15A and FIG. 15B corresponding to the lower face of FIG. 15A,.

Thereafter, at the position of the above-described groove 80, the transparent film 35, the wafer is diced through the fluorescent substance layer 30, the insulating film 18, and the resin layer 25 so as to separate into a plurality of semiconductor light emitting devices 100. For example, the dicing is performed using a dicing blade. Alternatively, the dicing may be performed using laser radiation.

When the dicing is performed, the substrate 10 has been already removed. In addition, since the semiconductor layer 15 is also removed in the groove 80, the semiconductor layer 15 can be prevented from damage, while the dicing is performed. In addition, the end portion (side surface) of the semiconductor layer 15 is covered with the insulating film 18. Thereby, the protection of the end portion can be obtained without any additional process after dicing into the plurality of semiconductor light emitting devices 100.

The embodiment is not limited to the above-described example, and another method may be used. For example, a fluorescent substance layer 30 having the light emitting face 30b and the side surface 30a may be molded by using a die. In addition, the light shielding film 35 can be selectively formed using a metal mask or the like. Furthermore, a resin film that includes a reflecting material such as titanium oxide may be used as the light shielding film 35.

In addition, the semiconductor light emitting device 100 may have a single chip structure that includes one semiconductor layer 15 or a multiple-chip structure that includes a plurality of semiconductor layers 15.

Since each diced device includes a package protecting the semiconductor 15 and the interconnection formed therein, and the above-described manufacturing process before dicing are performed in the wafer state, it is possible to significantly reduce the production cost. In other words, the interconnection and the packaging are completed at the diced state. Accordingly, the productivity can be improved, and, as a result, the lowered price can be achieved in an easy manner.

FIG. 17 is a schematic cross-sectional view illustrating a semiconductor light emitting device 200 according to a variation of the first embodiment.

In the semiconductor light emitting device 200, a p-side pad 51 is provided on the p-side electrode 16, covering the surface and the side surface of the p-side electrode. The p-side electrode 16, for example, contains at least one of nickel (Ni), gold (Au), and rhodium (Rh), which can form an alloy together with gallium (Ga) contained in the semiconductor layer 15. The p-side pad 51 has higher reflectance than the p-side electrode 16 for the light emitted from the light emitting layer 13 and, for example, contains silver (Ag) as its main ingredient.

An n-side pad 52 is provided on the n-side electrode, covering the surface and the side surface of the n-side electrode 17. The n-side electrode 17, for example, contains at least one of nickel (Ni), gold (Au), and rhodium (Rh), which can form an alloy together with gallium (Ga) contained in the semiconductor layer 15. The n-side pad 52 has higher reflectance than the n-side electrode 17 for the light emitted from the light emitting layer 13 and, for example, contains silver (Ag) as its main ingredient.

On the second face of the semiconductor layer 15, an insulating film 53 formed, for example, from a silicone oxide film, a silicon nitride film, or the like is provided on the periphery of the p-side electrode 16 and the periphery of the n-side electrode 17. The insulating film 53 is also provided between the p-side electrode 16 and the n-side electrode 17 and between the p-side pad 51 and the n-side pad 52, insulating each other.

An insulating film 54 such as a silicone oxide film, a silicon nitride film, or the like is provided on the insulating film 53, the p-side pad 51, and the n-side pad 52. In addition, the insulating film 54 is provided also on the side surface 15c of the semiconductor layer 15 and covers the side surface 15c.

A p-side interconnection layer 21 and an n-side interconnection layer 22 are provided on the insulating film 54. The p-side interconnection layer 21 is connected to the p-side pad 51 through the first opening 54a formed in the insulating film 54. The n-side interconnection layer 22 is connected to the n-side pad 52 through the second opening 54b formed in the insulating film 54.

The p-side interconnection layer 21 may be connected to the p-side pad 51 through a plurality of vias 21a, as shown in FIG.17, or may be connected to the p-side pad 51 through one post that has larger planar size than the via 21a.

The p-side metal pillar 23 that is thicker than the p-side interconnection layer 21 is provided on the p-side interconnection layer 21. The n-side metal pillar 24 that is thicker than the n-side interconnection layer 22 is provided on the n-side interconnection layer 22.

The resin layer 25 is stacked on the insulating film 54. The resin layer 25 covers the p-side interconnection that includes the p-side interconnection layer 21 and the p-side metal pillar 23, and the n-side interconnection that includes the n-side interconnection layer 22 and the n-side metal pillar 24. However, a face (a lower face in FIG.17) of the p-side metal pillar 23, which is disposed on a side opposite to the p-side interconnection layer 21, is exposed from the resin layer 25 so as to serve as the p-side external terminal 23a. Similarly, a face (a lower face in the diagram) of the n-side metal pillar 24, which is disposed on a side opposite to the n-side interconnection layer 22, is exposed from the resin layer 25 so as to serve as the n-side external terminal 24a.

Alternatively, it may be possible to make a semiconductor light emitting device of the side view type as described later, exposing the side surface of the p-side metal pillar 23 and the side surface of the n-side metal pillar 24.

The resin layer 25 is filled via the insulating film 54 inside the above-described groove 80 that separates the semiconductor layer 15 into multiple parts on the substrate 10. Accordingly, the side surface 15c of the semiconductor layer 15 is covered with the insulating film 54 that is an inorganic film and the resin layer 25 for protection.

the fluorescent substance layer 30 that has a light emitting face 30b and a side surface 30a that is in contact therewith is provided on the first face 15a. Then, the light shielding film 35 is provided on the side surface 30a, shielding the outgoing light from the side surface 30a. Accordingly, the color breakup of the outgoing light is suppressed, and the light distribution can be controlled such that light is emitted from the light emitting face 30b.

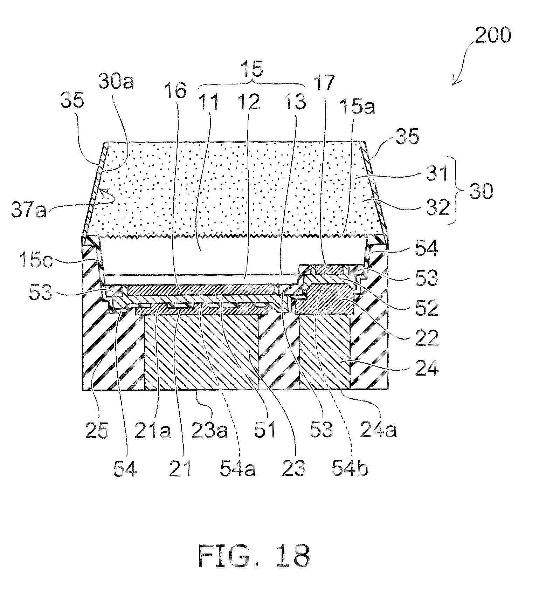

In addition, the side surface 37b of the groove 37 (see FIG. 13) reaching to the resin layer 25 may be formed by deeply cutting the fluorescent substance layer 30 as shown in FIG. 18. In other words, after forming the deep groove 37 by cutting the fluorescent substance layer 30, the insulating film 54, and the resin layer 25, and the light shielding film 35 is formed on the side surface of the groove 37. Accordingly, both the outgoing light from the side surface 30a of the fluorescent substance layer 30 and leaked light from the end face of the insulating film 54 can be shielded by the light shielding film 35.

As an alternative example of the embodiment, the p-side interconnection layer 21 and the n-side interconnection layer 22 may be directly bonded to the pads of the mounting substrate without providing the p-side metal pillar 23 and the n-side metal pillar 24.

Furthermore, the p-side interconnection layer 21 and the p-side metal pillar 23 are not limited to be the separately formed ones, and the p-side interconnection may be provided with the p-side interconnection layer 21 and the p-side metal pillar 23, which are formed into a single body in the same process. Similarly, the n-side interconnection layer 22 and the n-side metal pillar 24 are not limited to be the separately formed ones, and the n-side interconnection may be provided with the n-side interconnection layer 22 and the n-side metal pillar 24, which is formed into a single body in the same process.

### Second Embodiment

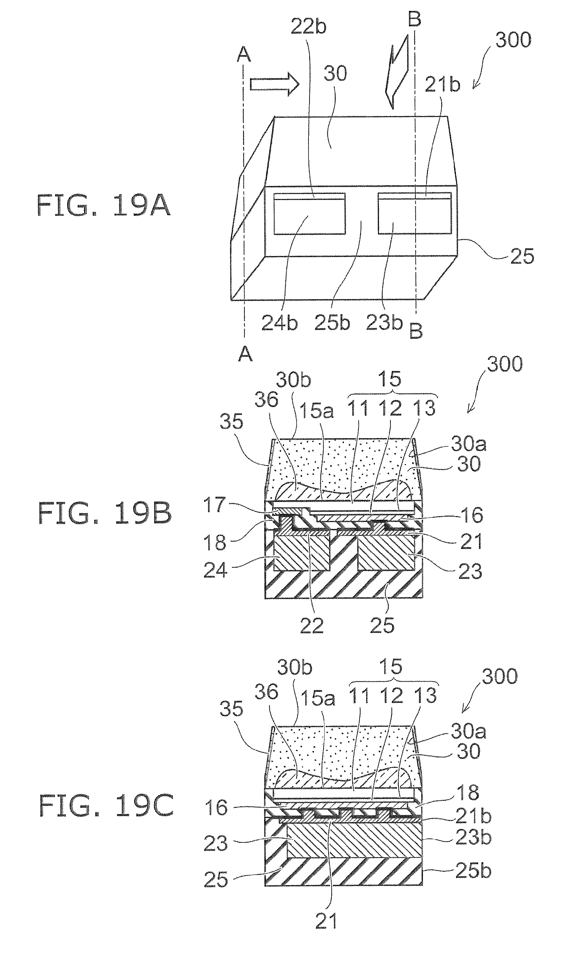

FIG. 19A is a schematic perspective view of a semiconductor light emitting device 2 according to a second embodiment. FIG. 19B is a cross-sectional view taken along line A - A shown in FIG. 19A. FIG. 19C is a cross-sectional view taken along line B - B shown in FIG. 19A.

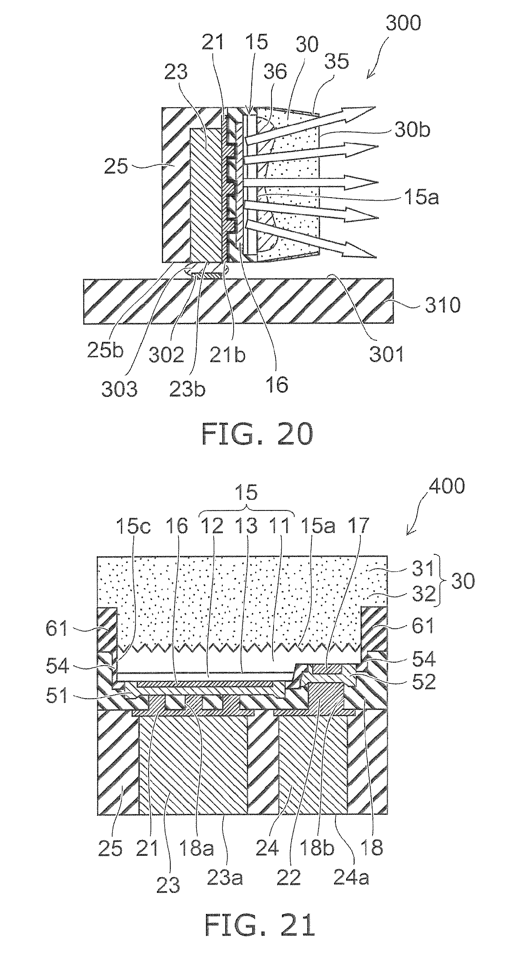

FIG. 20 is a schematic cross-sectional view of a light emitting module that has a configuration in which the semiconductor light emitting device 300 is mounted on a mounting substrate 310.

As shown in FIGS. 19A and 19C, a part of the side surface of the p-side metal pillar 23 is exposed from the resin layer 25 on a third face 25b that has a plane direction different from the first face 15a and the second face of the semiconductor layer 15. The exposed face serves as a p-side external terminal 23b for mounting the semiconductor light emitting device on an external mounting substrate.

The third face 25b is a face that is approximately perpendicular to the first face 15a and the second face of the semiconductor layer 15. The resin layer 25, for example, has four side surfaces of a rectangular shape, and one of the four side surfaces is the third face 25b.

A part of the side surface of the n-side metal pillar 24 is exposed from the resin layer 25 on the third face 25b. The exposed face serves as an n-side external terminal 24b for mounting the semiconductor light emitting device on the external mounting substrate.

In addition, as shown in FIG. 19A, a part of the side surface 21b of the p-side interconnection layer 21 is also exposed from the resin layer 25 on the third face 25b and serves as a p-side external terminal. Similarly, a part of the side surface 22b of the n-side interconnection layer 22 is also exposed from the resin layer 25 on the third face 25b and serves as an n-side external terminal.

Parts of the p-side metal pillar 23 other than the p-side external terminal 23b that is exposed on the third face 25b is covered with the resin layer 25. In addition, parts of the n-side metal pillar 24 other than the n-side external terminal 24b that is exposed on the third face 25b is covered with the resin layer 25.

In addition, parts of the p-side interconnection layer 21 other than the side surface 21b that is exposed on the third face 25b is covered with the resin layer 25. In addition, parts of the n-side interconnection layer 22 other than the side surface 22b that is exposed on the third face 25b is covered with the resin layer 25.

A lens 36 is provided between the first face 15a and the fluorescent substance layer 30. The lens 36 focuses the light emitted from the light emitting layer 13 and improves the light distribution. It may be also possible not to provide the lens 36.

In addition, the fluorescent substance layer 30 has the light emitting face 30b that faces the first face 15a and the side surface 30a that is in contact with the light emitting face 30b, and the light shielding film 35 is provided on the side surface 30a.

The semiconductor light emitting device 300, as shown in FIG. 20, is mounted in a posture in which the third face 25b faces the mounting face 301 of the mounting substrate 310. The p-side external terminal 23b and the n-side external terminal 24b that are exposed on the third face 25b are bonded to the pad 302 that is formed on the mounting face 301 through soldering 303. In addition, an interconnection pattern is formed on the mounting face 301 of the mounting substrate 310, and the pad 302 is connected to the interconnection pattern.

The third face 25b is approximately perpendicular to the first face 15a that is the major light emitting face. Accordingly, in the posture in which the third face 25b is disposed toward the lower side, i.e. facing the mounting face 301 side, the first face 15a faces in the horizontal direction, not the upper side of the mounting face 301. That is, the semiconductor light emitting device 300 is a so-called side view type device in which light is emitted in the horizontal direction in a case where the mounting face 301 is set as the horizontal plane.

In the semiconductor light emitting device 300 of the side view type, it is preferable that light is emitted from the light emitting face 30b that faces the first face 15a. In the embodiment, the light distribution in which the outgoing light from the light emitting face 30b is dominant can be realized by providing the light shielding film 35 on the side surface 30a of the fluorescent substance layer 30.

### Third Embodiment

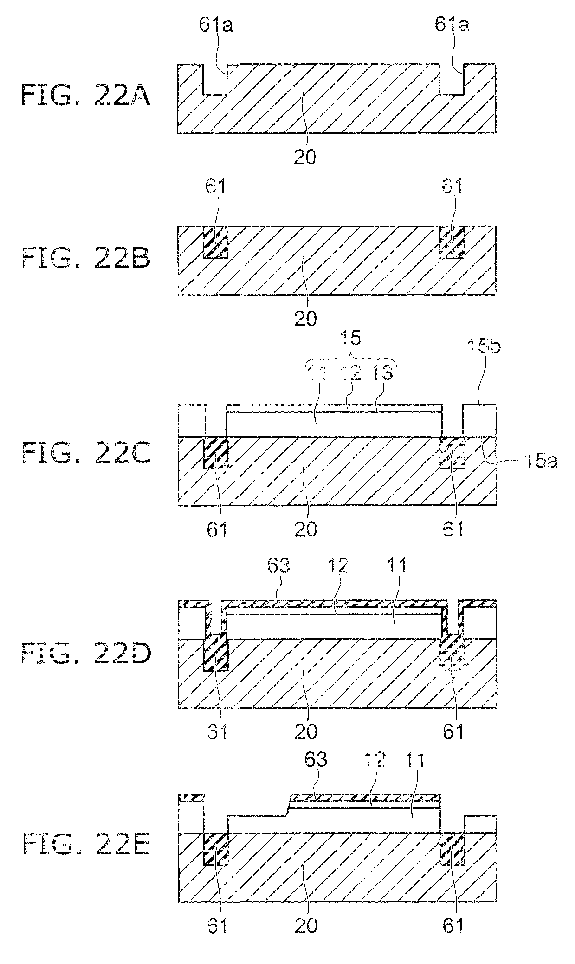

FIG. 21 is a schematic cross-sectional view of a semiconductor light emitting device 400 according to a third embodiment. The semiconductor light emitting device 400 includes a semiconductor layer and a fluorescent substance layer 30. The semiconductor layer 15 has a first face 15a and a second face 15b (see FIG. 22C) on a side opposite to the first face 15a and includes the light emitting layer 13. The fluorescent substance layer 30 is provided on the first face 15a and includes a transparent resin 31 and fluorescent substances 32 that are dispersed in the transparent resin.

The semiconductor layer 15 has the first face 15a and the second face that is located on a side opposite to the first face 15a. Electrodes and an interconnection part are provided on the second face side, and the light is emitted mainly to the outer side from the first face 15a on which the electrodes and the interconnection part are not provided.

The semiconductor layer 15 includes a first semiconductor layer 11 and a second semiconductor layer 12. The first semiconductor layer 11 and the second semiconductor layer 12, for example, contain gallium nitride. The first semiconductor layer 11 may include an underlying buffer layer, an n-type GaN layer, and the like. The second semiconductor layer 12 includes a p-type GaN layer, a light emitting layer (active layer) 13, and the like. The light emitting layer 13 may include a material that emits blue light, purple light, blue-purple light, ultraviolet light, or the like. The semiconductor layer 15 has a region including the light emitting layer 13 and a region not including the light emitting region 13.

The second face of the semiconductor layer 15 is formed in a concavo-convex shape, and a convex part includes the light emitting layer 13. A p-side electrode 16 is provided on the surface of the second semiconductor layer 12, which is the top surface of the convex part. In other words, the p-side electrode 16 is provided on a first region of the second face that is the top surface of the convex part of the semiconductor layer 15.

On the second face side of the semiconductor layer 15, a part that does not include the light emitting layer 13 is provided on a side of the convex part, where the light emitting layer 13 is removed and a surface of the first semiconductor layer 11 is exposed. An n-side electrode 17 is provided on the exposed surface of the first semiconductor layer 11. In other words, the n-side electrode 17 is provided in a second region of the second surface that is the surface of the part not including the light emitting layer 13. Further, a p-side pad 51 is formed on the p-side electrode 16, covering a surface thereof. An n-side pad 52 is formed on the n-side electrode 17, covering a surface thereof.

The insulating film 54 is formed on a side face 15c of the semiconductor layer 15 and a side face of the convex part, so as to protect the side faces of the light emitting layer 13 and the second semiconductor layer 12.

On the second face side of the semiconductor layer 15, the area of the first region is larger than the area of the second region. The p-side electrode 16 provided on the first region also has a larger area than the n-side electrode 17. Thus, it is possible to achieve a wide light emitting region.

The first insulating film (insulating film 18) is provided on the second face side of the semiconductor layer 15. The insulating film 18 covers the semiconductor layer 15 via the insulating film 54, the p-side pad 51 and the n-side pad 52. The insulating film 18 is, for example, a resin such as polyimide that is superior for the patterning of fine openings. Alternately, an inorganic film such as silicon oxide, silicon nitride and the like may be preferably used for the insulating film 18.

The p-side interconnect layer 21 and the n-side interconnect layer 22 is separately provided from each other on a side opposite to the second face of the semiconductor layer 15. The p-side interconnect layer 21 is electrically connected to the p-side electrode through a plurality of openings 18a (first openings) formed in the insulating film 18. The n-side interconnect layer 22 is electrically connected to the n-side electrode 17 through an opening 18b (a second opening) formed in the insulating film 18.
The p-side metal pillar 23 is provided on a face of the p-side interconnect layer 21 opposite to the p-side electrode 16. Then, a p-side interconnection according to the embodiment includes the p-side interconnection layer 21, the p-side metal pillar 23, and a metal film 19 that serves as a seed layer to be described later.

An n-side metal pillar 24 is provided on a face of the n-side interconnection layer 22 opposite to the n-side electrodes 17. Then, an n-side interconnection according to the embodiment includes the n-side interconnection layer 22, the n-side metal pillar 24, and the metal film 19 that is used as the seed layer.

A resin layer 25 serving as a second insulating film is stacked on the insulating film 18. The resin layer 25 covers the periphery of the p-side interconnection and the periphery of the n-side interconnection. In addition, the resin layer 25 is filled up between the p-side metal pillar 23 and the n-side metal pillar 24.

The side surfaces of the p-side metal pillar 23 and the n-side metal pillar 24 are covered with the resin layer 25. A face of the p-side metal pillar 23 opposite to the p-side interconnection layer 21 is exposed from the resin layer 25 and serves as a p-side external terminal 23a. A face of the n-side metal pillar 24 opposite to the n-side interconnection layer 22 is exposed from the resin layer 25 and serves as an n-side external terminal 24a.

The p-side external terminal 23a and the n-side external terminal 24a are bonded to a pad formed in a mounting substrate through a bonding member such as a solder, other metal, a material having conductivity, or the like.

The p-side external terminal 23a and the n-side external terminal 24a are exposed on the same face (the lower face in FIG. 21) of the resin layer 25, having a longer distance therebetween than a distance between the p-side interconnection layer 21 and the n-side interconnection layer 22 on the insulating film 18. The p-side external terminal 23a and the n-side external terminal 24a are separated from each other with such a distance, so that the external terminals do not form a short circuit via solder or the like at the time of being mounted on the mounting substrate.

On the other hand, the p-side interconnection layer 21 may approach the n-side interconnection layer 22 up to a process limit, and accordingly, the area of the p-side interconnection layer 21 may be widened. Thereby, the contact area can be enlarged between the p-side interconnection layer 21 and the p-side electrode 16.

Furthermore, the area of the p-side interconnection layer 21 that is in contact with the p-side electrodes 16 through the plurality of first openings 18a is possible to be larger than the area of the n-side interconnection layer 22 that is in contact with the n-side electrodes 17 through the second openings 18b.

As a result, the current distribution toward the light emitting layer 13 is improved, and the heat dissipation of the light emitting layer 13 can be improved.

In the n-side interconnection layer 22, the portion extending on the insulating film 18 can be formed to have larger area than the contact portion that is in contact with the n-side electrodes 17.

According to the embodiment, a high optical output can be acquired, since the light emitting layer 13 is formed over the first region that is larger than the second region on which the n-side electrode 17 is provided. In addition, the n-side interconnection layer 22 having a larger area than the n-side electrode 17 can be provided on the mounting face side.

The first semiconductor layer 11 is electrically connected to the n-side metal pillar 24 having the n-side external terminal 24a through the n-side electrode 17, the metal film 19, and the n-side interconnection layer 22. The second semiconductor layer 12 including the light emitting layer 13 is electrically connected to the p-side metal pillar 23 having the p-side external terminal 23a through the p-side electrode 16, the metal film 19, and the p-side interconnection layer 21.

The p-side metal pillar 23 is thicker than the p-side interconnection layer 21, and the n-side metal pillar 24 is thicker than the n-side interconnection layer 22. Each thickness of the p-side metal pillar 23, the n-side metal pillar 24, and the resin layer 25 is larger than that of the semiconductor layer 15. Here, the "thickness" represents a thickness in the vertical direction in FIG. 21.

In addition, each thickness of the p-side metal pillar 23 and the n-side metal pillar 24 is larger than that of a stacked body that includes the semiconductor layer 15, the p-side electrode 16, the n-side electrode 17, and the insulating film 18. In addition, the aspect ratio (the ratio of the thickness to the planar size) of each one of the metal pillars 23 and 24 is not limited to be one or more, and the ratio may be less than one. In other words, each thickness of the metal pillars 23 and 24 may be smaller than the planar size of the metal pillars 23 and 24.

According to the embodiment, even though a substrate 10 used for forming the semiconductor layer 15 is removed as described later, the mechanical strength of the semiconductor light emitting device 100 can be maintained, since the semiconductor layer 15 is stably supported by the p-side metal pillar 23, the n-side metal pillar 24, and the resin layer 25.

In the embodiment, a wall 61 is provided along the outer edge of the semiconductor layer 15 on the first face 15 side. The wall 61, for example, is a silicone oxide film and controls the light distribution of the light emitted from the light emitting layer 13. In addition, when the fluorescent substance layer 30 is formed on the first face 15, the wall 61 holds the transparent resin 31 so as to have a uniform thickness.

A fine concavo-convex is formed on the first face 15a of the semiconductor layer 15 using wet etching (frost process), where an alkali-based solution is applied to the first face 15a. The light emitted from the light emitting layer 13 can be extracted outside through the first face 15a, suppressing light reflection at various incident angles by providing the concavo-convex on the first face 15a.

A fluorescent substance layer 30 is provided on the first face 15a. The fluorescent substance layer 30 includes a transparent resin 31 and a plurality of fluorescent substances 32 dispersed in the transparent resin 31. The transparent resin 31 has transparency for the lights emitted from the light emitting layer 13 and the fluorescent substance 32. For example, a silicone resin, an acrylic resin, a phenyl resin, or the like may be used as the transparent resin 31. The fluorescent substance 32 absorbs the light emitted from the light emitting layer 13 as excited light and emits wavelength-converted light. Accordingly, the semiconductor light emitting device 100 can emit mixed lights emitted from the light emitting layer 13 and the fluorescent substance 32.

In a case where the fluorescent substance 32 is a yellow fluorescent substance that emits yellow light, a white color, a light bulb color, or the like can be obtained as a mixed color of blue light emitted from the light emitting layer 13, which contains a GaN-based material, and the yellow light emitted from the fluorescent substance 32. In addition, the fluorescent substance layer 30 may be configured to contain a plurality of types of fluorescent substances (for example, a red fluorescent substance that emits red light and a green fluorescent substance that emits green light).

Next, a method for manufacturing the semiconductor light emitting device 400 according to the embodiment will be described with reference to FIGS. 22A to 25B. FIGS. 22A to 25B show partial cross-sections of a wafer in the manufacturing process.

In the manufacturing process described blow, the same elements as that of the first embodiment or the second embodiment, which has not been described in detail, is formed using the same method and the same material above described.

As shown in FIG. 22A, a groove 61a is formed on the surface of a substrate 20. The groove 61a, for example, is formed in the lattice pattern. In the embodiment, a silicon substrate is used as the substrate 20, because processing such as etching can be easily performed therein.

Next, a member that serves as a material of the wall 61 is embedded inside the groove 61a. For example, a silicone oxide film is formed on the substrate 20 using a CVD method. Thereafter, the silicon oxide film that becomes the wall 61 is embedded inside the groove 61a through the steps for etching back or polishing and removing the silicone oxide film,.

Subsequently, as shown in FIG. 22C, the first semiconductor layer 11, the light emitting layer 13, and the second semiconductor layer 12 are sequentially epitaxially grown on the substrate 20 so as to form the semiconductor layer 15. For example, a MOCVD method may be used for the growth of each layer. Then, the growth conditions are controlled so that each epitaxial layer does not grow on the groove 61 embedded with the silicone oxide film. Accordingly, the semiconductor layer 15 is selectively formed on the substrate 20.

Next, an insulating film 63 that covers the surface of the semiconductor layer 15 is formed. The insulating film 63 is, for example, a silicone oxide film that is formed using the CVD method.

Subsequently, the insulting film 63 is selectively removed so as to expose parts of the second semiconductor layer 12. Then, as shown in FIG. 22E, the second semiconductor layer 12 and the light emitting layer 13 are selectively removed, whereby a convex parts are formed on the semiconductor layer 15. Accordingly, the second region that does not include the light emitting layer 13 in which the first semiconductor layer 11 is exposed and the first region (convex part) that includes the light emitting layer 13 are formed in the semiconductor layer 15.

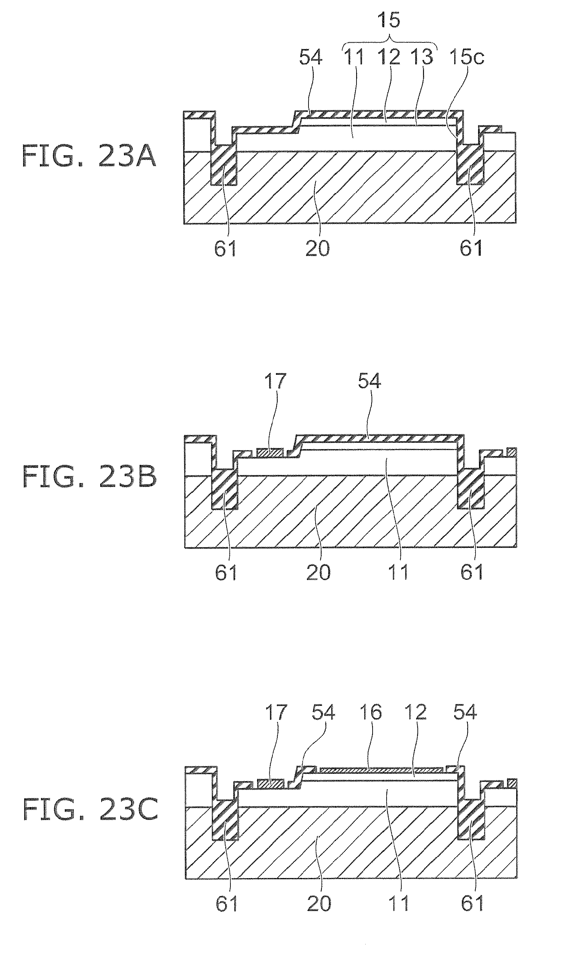

Next, the insulating film 63 is removed, and the insulating film 54 that covers the surface of the semiconductor layer 15 is formed as shown in FIG. 23A. The insulating film 54 is, for example, a silicone oxide film that is formed using a CVD method.

Next, as shown in FIG. 23B, an opening is formed in the insulting film 54 that is provided on the surface of the first semiconductor layer 11, and an n-side electrode 17 that is in contact with the first semiconductor layer 11 is formed in the second region.

Subsequently, as shown in FIG. 23C, an opening is formed in the insulating film 54 provided on the first region, and a p-side electrode 16 that is in contact with the second semiconductor layer 12 is formed therein.

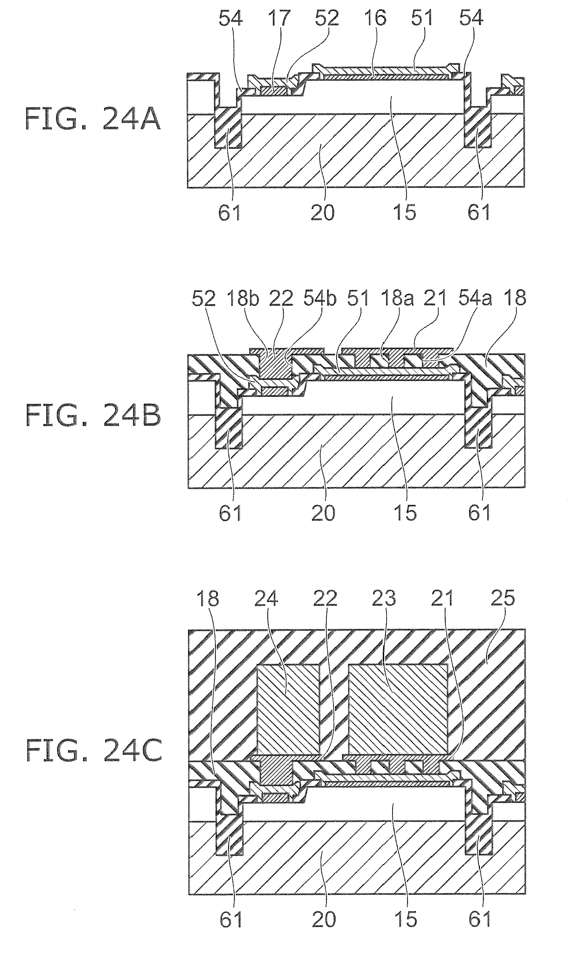

Next, a p-side pad 51 that covers the p-side electrode 16 and an n-side pad 52 that covers the n-side electrode 17 are formed as shown in FIG. 24A. The insulating film 54 that covers the side surface of the convex part electrically separates the p-side pad 51 and the n-side pad 52 from each other.

Next, as shown in FIG. 24B, an insulating film 18 that covers the p-side pad 51, the n-side pad 52, and the insulating film 54 is formed thereon. For example, using a polyimide film as the insulating film 18, the second face side of the semiconductor layer 15 can be covered so as to be flat. In addition, an opening 18a that communicates with the p-side pad 51 and an opening 18b that communicates with the n-side pad 52 can be easily formed using a photosensitive polyimide and photolithography.

Subsequently, a p-side interconnection layer 21 electrically connected to the p-side pad 51 through the opening 18a and an n-side interconnection layer 22 electrically connected to the n-side pad 52 through the opening 18b are formed on the insulating film 18.

Although a plurality of openings 18a that communicate with the p-side pad 51 is provided in the embodiment, the p-side interconnection layer 21 may be electrically connected to the p-side pad 51 through one opening that has an area larger than the opening 18a.

Next, as shown in FIG. 24C, a p-side metal pillar 23 is formed on the p-side interconnection layer 21, and an n-side metal pillar 24 is formed on the n-side interconnection layer 22. Then, a resin layer 25 is formed on the insulating layer 18, which covers the p-side interconnection layer 21, the n-side interconnection layer 22, the p-side metal pillar 23, and the n-side metal pillar 24.

In addition, in the above-described process, the p-side interconnection layer 21, the n-side interconnection layer 22, the p-side metal pillar 23, and the n-side metal pillar 24, for example, may be formed using Cu plating in which a metal film 19 (see FIGS. 7A, 7B, 9A, and 9B) is used as a conduction layer.

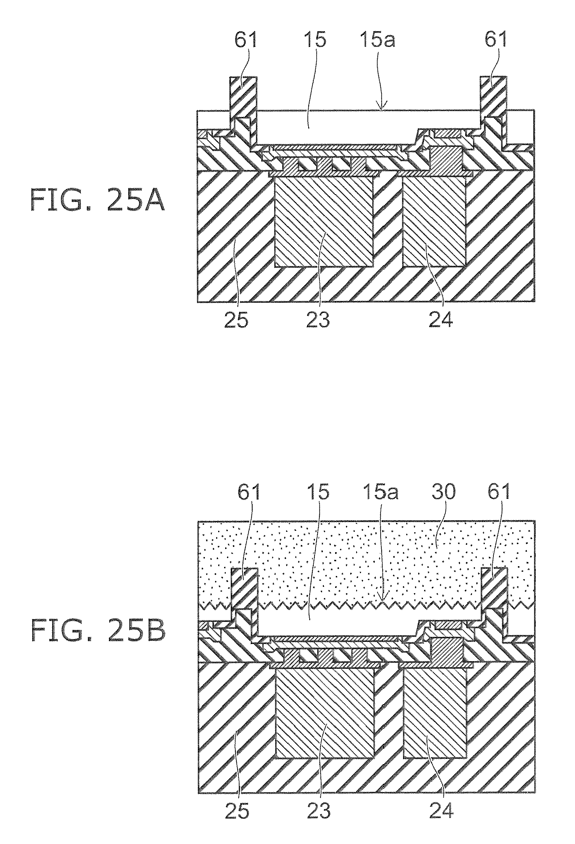

Next, the substrate 20 is removed on the first face 15a side of the semiconductor layer 15 as shown in FIG. 25A. For example, in a case where the substrate 20 is a silicon substrate, the substrate 20 can be removed by wet etching. A material having resistance against a silicon etching solution is used for the wall 61 that is embedded in the groove 61a. Accordingly, the wall 61 remains along the outer edge of the semiconductor layer 15 as shown in FIG. 25A.

Next, fine concavo-convex is formed, for example, by performing wet etching for the first face 15a of the semiconductor layer 15 as shown in FIG. 25B. Subsequently, a fluorescent substance layer 30 is formed on the first face 15a. The wall 61 suppresses the flow of the transparent resin 31 of the liquid phase with which the first face 15a is coated, and thereby improving the uniformity of the thickness of the fluorescent substance layer 30.

Subsequently, on the second face side of the semiconductor layer 15, the resin layer 25 is thinned, for example, by grinding or polishing, and surfaces of the p-side metal pillar 23 and the n-side metal pillar 24 are exposed so as to form the p-side external terminal 23a and the n-side external terminal 24a. Then, the semiconductor light emitting device 400 is completed by cutting the portion in which the wall 61 is formed, using a dicing blade.

As described above, in the embodiment, the flow of the transparent resin 31 is suppressed by providing the wall 61 on the first face 15a side of the semiconductor layer 15, whereby improving the uniformity of the thickness of the fluorescent substance layer 30. In addition, it becomes possible to selectively form the semiconductor layer 15 by embedding a member in the groove 61a, on which the semiconductor layer 15 is not grown. Accordingly, the etching process (see FIGS. 3A and 3B) can be omitted, whereby improving the manufacturing efficiency.

In addition, the height of the wall 61 can be changed, by adjusting the depth of the groove 61a provided in the substrate 20. Thereby, it becomes possible to control the light distribution of the light emitted from the light emitting layer 13 through the fluorescent substance layer 30 and the fluorescence radiated from the fluorescent substance 32.

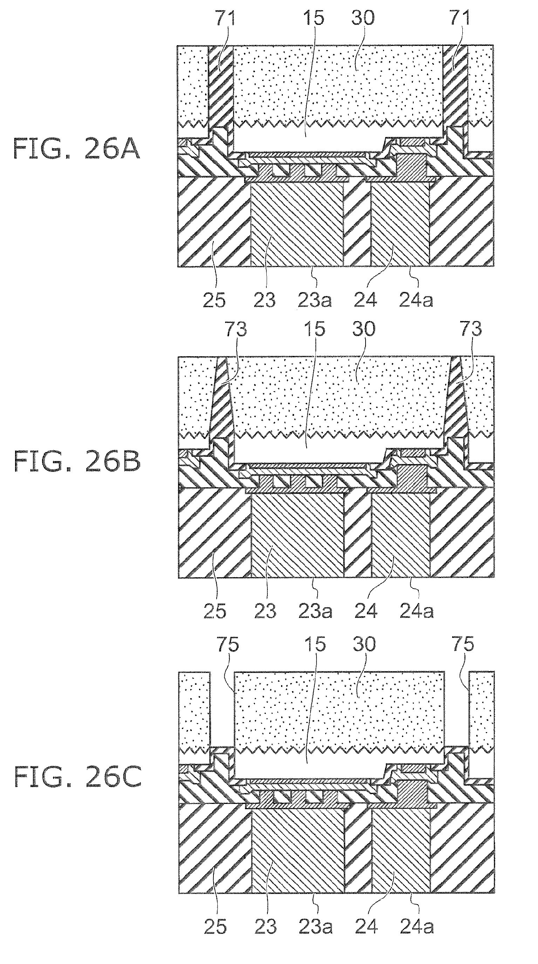

Next, variations of the embodiment will be described with reference to FIGS. 26A to 27C. FIGS. 26A to 27C shows partial cross-sections of the wafer after the resin layer 25 is thinned.

In the example shown in FIG. 26A, the wall 71 formed along the outer edge of the semiconductor layer 15 is provided at a height that is the same as the thickness of the fluorescent substance layer 30. Accordingly, the thickness of the fluorescent substance layer 30 can be formed to be further uniform, whereby suppressing the variations in the chromaticity of the semiconductor light emitting device 400.

In the example shown in FIG. 26B, the wall 73 that is formed along the outer edge of the semiconductor layer 15 is provided in a taper shape in which the horizontal width is narrowed in the light radiation direction. Accordingly, the light is reflected by the side surface of the wall 73, and the light propagating in the horizontal direction in the drawing is suppressed, whereby suppressing the color breakup.

In the example shown in FIG. 26C, the wall 71 shown in FIG. 26A is removed after the fluorescent substance layer 30 is formed on the first face 15a side of the semiconductor layer 15, for example. Accordingly, the groove 75 along the outer edge of the semiconductor layer 15 is provided in the fluorescent substance layer 30. Therefore, the disturbance of the side surface of the fluorescent substance layer 30 can be suppressed after dicing. Then, the light radiation from the side surface of the fluorescent substance layer 30 becomes uniform, whereby suppressing the color breakup.

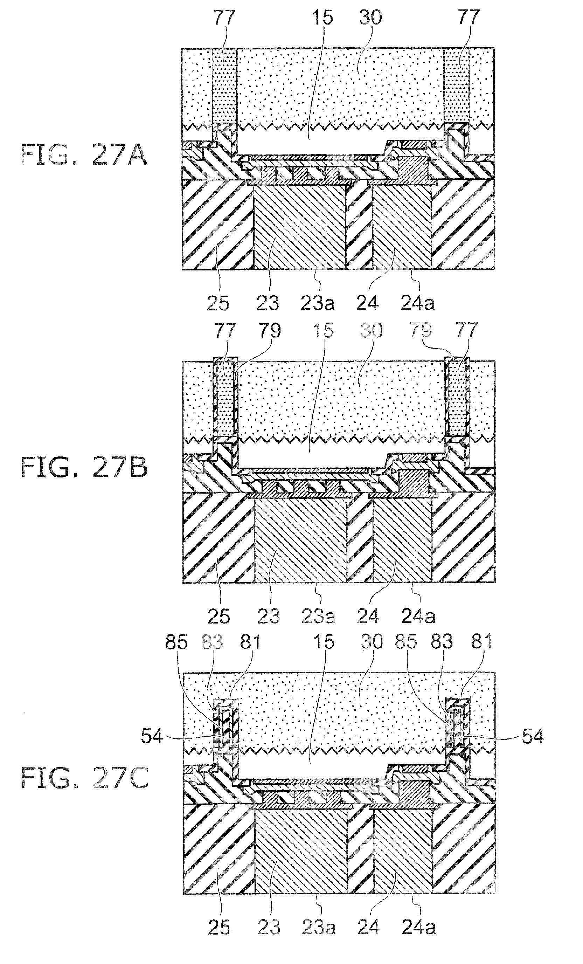

In the example shown in FIG. 27A, a resin containing fine particles of titanium oxide, for example, that is, so called a white resin is used for the wall 77 formed along the outer edge of the semiconductor layer 15. Accordingly, the wall 77 reflects the light emitted from the light emitting layer 13 and the fluorescence radiated by the fluorescent substance 32. Therefore, the light emitted from the upper face of the fluorescent substance layer 30 increases, improving the light extracting efficiency.

In the example shown in FIG. 27B, a reflecting member (metal film) 79 is provided on the surface of the wall 77. Accordingly, the light emitted from the light emitting layer 13 and the fluorescence radiated from the fluorescent substance 32 are reflected more efficiently, whereby improving the light extracting efficiency.

In the example shown in FIG. 27C, the wall 81 includes an insulating layer 83, a reflecting member 85, and an insulating layer 54 from the outer side. The insulting layer 83, for example, is a silicone oxide film, and the reflecting member 85, for example, is a metal film including Ag or Al. In the wall 81, the reflecting member 85 reflects the light emitted from the light emitting layer 13 and the fluorescence radiated from the fluorescent substance 32. Accordingly, the ratio of the light radiated from the upper face of the fluorescent substance layer 30 can be raised, whereby improving the light extracting efficiency and suppressing the color breakup.

The structure shown in FIG. 27C can be manufactured in the following order. For example, in a process shown in FIG. 22B, an insulating film 83 is formed on the inner face of the groove 61a. Subsequently, as shown in FIG. 22C, the semiconductor layer 15 is selectively grown, and then, a reflecting member 85 is formed on the insulating film 83 on the inner side of the groove 61a. Subsequently, while forming the insulating film 54, the inside of the groove 61a is simultaneously embedded with the insulating film 54. In addition, the reflecting member 85 may be simultaneously formed, when forming the p-side electrode 16 or the n-side electrode 17.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A method for manufacturing a semiconductor light emitting device comprising:
forming a fluorescent substance layer (30) on a first face of a semiconductor layer (15), the fluorescent substance layer (30) including a resin (31) and fluorescent substances (32) dispersed in the resin (31), and having a light emitting face on a side opposite to the first face of the semiconductor layer (15) and a side face connecting to the light emitting face with an angle of 90 degree or more between the light emitting face and the side face; and
forming a light shielding film (35) on the side face of the fluorescent substance layer (30), the light shielding film (35) shielding a light emitted from a light emitting layer (13) included in the semiconductor layer (15) and a light radiated from the fluorescent substances (32).

2. The method according to claim 1, wherein the fluorescent substance layer (30) formed on the semiconductor layer (15) is cut so as to form a groove including the side face.

3. The method according to claim 1 or claim 2, wherein the fluorescent substance layer (30) formed on the semiconductor layer (15) is cut so as to form a V groove including the side face.

4. The method according to any of claims 1-3, further comprising:
forming a first region including the light emitting layer (13) and a second region not including the light emitting layer (13) on a second face side of the semiconductor layer (15) opposite to the first face;
forming a p-side electrode (16) on the first region and an n-side electrode (17) on the second region;
forming a first insulating film (18) over and around the semiconductor layer (15) on the second face side, the first insulating film (18) including a first opening communicating with the p-side electrode (16) and a second opening communicating with the n-side electrode (17); and
forming a p-side interconnection (19, 21, 23) electrically connected to the p-side electrode (16) via the first opening and an n-side interconnection (19, 22, 24) electrically connected to the n-side electrode (17) via the second opening on the first insulating film (18);
wherein the fluorescent substance layer (30) is formed on the first face and the first insulating film (18) exposed around the first face, and the groove including the side face is formed by cutting the fluorescent substance layer (30) and the first insulating film (18).

5. The method according to any of claims 1-4, further comprising:
forming a first region including the light emitting layer (13) and a second region not including the light emitting layer (13) on a second face side of the semiconductor layer (15) opposite to the first face;
forming a p-side electrode (16) on the first region and an n-side electrode (17) on the second region;
forming a first insulating film (18) over the semiconductor layer (15) on the second face side, the first insulating film (18) including a first opening communicating with the p-side electrode (16) and a second opening communicating with the n-side electrode (17);
forming a p-side interconnection layer (21) electrically connected to the p-side electrode (16) via the first opening and an n-side interconnection layer (22) electrically connected to the n-side electrode (17) via the second opening on the first insulating film (18);
forming a p-side metal pillar (23) on the p-side interconnection layer (21) and an n-side metal pillar (24) on the n-side interconnection layer (22), the p-side metal pillar (23) being thicker than the p-side interconnection layer (21), and the n-side metal pillar (24) being thicker than the n-side interconnection layer (22); and
forming a second insulating film (25) over and around the p-side metal pillar (23), the n-side metal pillar (24) and the semiconductor layer (25),
wherein the fluorescent substance layer (30) is formed on the first face and over the second insulating film (25), and the groove including the side face is formed by cutting the fluorescent substance layer (30) and the second insulating film (25).

6. The method according to any of claims 1-5, wherein the step for forming the light shielding film (35) comprising:
forming the light shielding film (35) both on the light emitting face and on the side face, and
removing the light shielding film (35) formed on the fluorescent substance layer (30) so as to expose the light emitting face.

7. The method according to any of claims 1-6, wherein the light shielding film (35) reflects the light emitted from the light emitting layer (13) and the light radiated from the fluorescent substances (32).

8. The method according to any of claims 1-7, wherein the light shielding film (35) includes a metal film reflecting the light emitted from the light emitting layer (13) and the light radiated from the fluorescent substances (32) and a metal protecting film preventing the metal film from oxidation or sulfuration.

9. A semiconductor light emitting device comprising:
a semiconductor layer (15) having a first face, a second face disposed on a side opposite to the first face, and a light emitting layer (13), the semiconductor layer (15) having a first region including the light emitting layer (13) and a second region not including the light emitting layer (13);
a p-side electrode (16) provided on the first region on the second face side;
an n-side electrode (17) provided on the second region on the second face side;
a fluorescent substance layer (30) provided on the first face of a semiconductor layer (15), the fluorescent substance layer (30) including a resin (31) and fluorescent substances (32) dispersed in the resin (31), and having a light emitting face on a side opposite to the first face of the semiconductor layer (15) and a side face connecting to the light emitting face with an angle of 90 degree or more between the light emitting face and the side face; and
a light shielding film (35) providing on the side face and shielding a light emitted from the light emitting layer (13) and a light radiated from the fluorescent substances (32).

10. The device according to claim 9, wherein the light shielding film (35) reflects the light emitted from the light emitting layer (13) and the light radiated from the fluorescent substances (32).

11. The device according to claim 9 or claim 10, wherein the light shielding film (35) includes a metal film reflecting the light emitted from the light emitting layer (13) and the light radiated from the fluorescent substances (32) and a metal protecting film preventing the metal film from oxidation or sulfuration.

12. The device according to any of claims 9-11, wherein concavo-convex is provided on the first face, and the fluorescent substance layer (30) covers the concavo-convex.

13. The device according to any of claims 9-12, further comprising:
a first insulating film (18) provided on a side of the second face, the first insulating film (18) including a first opening communicating with the p-side electrode (16) and a second opening communicating with the n-side electrode (17);
a p-side interconnection (19, 21, 23) provided on the first insulating film (18) and electrically connected to the p-side electrode (16) through the first opening; and
an n-side interconnection (19, 22, 24) provided on the first insulating film (18) and electrically connected to the n-side electrode (17) through the second opening.

14. The device according to claim 13, further comprising a second insulating film (25) provided between the p-side interconnection (19, 21, 23) and the n-side interconnection (19, 22, 24).

15. The device according to claim 13 or claim 14, wherein
the p-side interconnection (19, 21, 23) includes a p-side interconnection layer (21) provided both inside the first opening and on the first insulating film (18), and a p-side metal pillar (23) provided on the p-side interconnection layer (21), the p-side metal pillar (13) being thicker than the p-side interconnection layer (21); and
the n-side interconnection (19, 22, 24) includes an n-side interconnection layer (22) provided both inside the second opening and on the first insulating film (18), and an n-side metal pillar (24) provided on the n-side interconnection layer (22), the n-side metal pillar (24) being thicker than the n-side interconnection layer (22).

16. The device according to claim 15, wherein the second insulating film (25) covers a periphery of the p-side metal pillar (23) and a periphery of the n-side metal pillar (24).
